(19) Europäisches Patentamt
European Patent Office
Office européen des brevets

(11) EP 2 453 581 A1

(12) EUROPEAN PATENT APPLICATION
published in accordance with Art. 153(4) EPC

(43) Date of publication:
16.05.2012 Bulletin 2012/20

(51) Int Cl.:
H04B 1/40 (2006.01)          H01P 5/08 (2006.01)
H01Q 1/24 (2006.01)

(21) Application number: 11813647.2

(22) Date of filing: 19.01.2011

(86) International application number:
PCT/JP2011/050883

(87) International publication number:
WO 2012/020576 (16.02.2012 Gazette 2012/07)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 11.08.2010   JP 2010180088
17.09.2010   JP 2010209295
19.01.2011   JP 2011008533

(71) Applicant: Murata Manufacturing Co., Ltd.
Kyoto 617-8555 (JP)

(72) Inventors:
• ISHIZUKA Kenichi
Nagaokakyo-shi
Kyoto 617-8555 (JP)
• KATO Noboru
Nagaokakyo-shi
Kyoto 617-8555 (JP)

(74) Representative: Zimmermann, Tankred Klaus et al
Schoppe, Zimmermann, Stöckeler
Zinkler & Partner
P.O. Box 246
82043 Pullach (DE)

(54) FREQUENCY-STABILIZING CIRCUIT, ANTENNA APPARATUS AND COMMUNICATION TERMINAL DEVICE

(57)    A frequency stabilization circuit (25) includes four coiled conductors (L1 to L4), the first coiled conductor (L1) and the second coiled conductor (L2) are connected in series to each other, thereby configuring a first series circuit, the third coiled conductor (L3) and the fourth coiled conductor (L4) are connected in series to each other, thereby configuring a second series circuit, the first series circuit is connected between an antenna port and a power feeding port, and the second series circuit is connected between the antenna port and the ground. The first coiled conductor (L1) and the second coiled conductor (L2) are wound so that a first closed magnetic circuit (a loop indicated by a magnetic flux FP12) is configured, and the third coiled conductor (L3) and the fourth coiled conductor (L4) are wound so that a second closed magnetic circuit (a loop indicated by a magnetic flux FP34) is configured.

FIG. 10

EP 2 453 581 A1

**Description**

Technical Field

The present invention relates to a frequency stabilization circuit, an antenna device, and a communication terminal device. In addition, in particular, the present invention relates to an antenna device installed in a communication terminal device such as a mobile phone or the like, a frequency stabilization circuit embedded in the antenna device, and a communication terminal device equipped with the antenna device.

Background Art

In recent years, as described in PTLs 1, 2, and 3, as antenna devices installed in mobile communication terminals, there have been proposed housing dipole antenna, in each of which a metallic body (a ground plate of a printed wiring substrate or the like) placed within a terminal housing is used as a radiation element. In the housing dipole antenna of this type, power is differentially fed to two housing ground plates (a ground plate of a main body portion housing and a ground plate of a lid portion housing) in a folding or sliding mobile communication terminal, and hence it is possible to obtain the performance as a dipole antenna. In addition, since a ground plate provided in a housing is used as a radiation element, it is not necessary to separately provide a dedicated radiation element and it is possible to enhance the downsizing of the mobile communication terminal.

Citation List

Patent Literature

PTL 1: Japanese Unexamined Patent Application Publication No. 2004-172919
PTL 2: Japanese Unexamined Patent Application Publication No. 2005-6096
PAL 3: Japanese Unexamined Patent Application Publication No. 2008-118359

Summery of Invention

Technical Problem

However, in the above-mentioned housing dipole antenna, depending on the placement situation of a neighboring metallic body (a proximally placed electronic component, a hinge component, or the like) in addition to the shape of the ground plate used as the radiation element and the shape of the housing, the impedance of the ground plate turns out to be changed. Therefore, in order to minimize the energy loss of a high-frequency signal, it has been necessary to design an impedance-matching circuit with respect to each model. In addition, in the folding or sliding mobile communication terminal, depending on a positional relationship between the main body portion housing and the lid portion housing (for example, a state in which the lid portion is closed and a state in which the lid portion is opened, in the folding type), the impedance of the ground plate or the impedance-matching circuit turns out to be changed. Therefore, in some cases, a control circuit or the like is necessary for controlling the impedance.

Accordingly, an object of the present invention is to provide a frequency stabilization circuit, an antenna device, and a communication terminal device, which are capable of stabilizing the frequency of a high-frequency signal without being affected by the shape of a radiator or a housing, the placement situation of a neighboring component, or the like.

Solution to Problem

(1) A frequency stabilization circuit according to a first illustrative embodiment includes
at least a first coiled conductor, a second coiled conductor, a third coiled conductor, and a fourth coiled conductor, wherein
the first coiled conductor and the second coiled conductor are connected in series to each other, thereby configuring a first series circuit,
the third coiled conductor and the fourth coiled conductor are connected in series to each other, thereby configuring a second series circuit,
the first coiled conductor and the second coiled conductor are wound so that a first closed magnetic circuit is configured on the basis of the first coiled conductor and the second coiled conductor, and

the third coiled conductor and the fourth coiled conductor are wound so that a second closed magnetic circuit is configured on the basis of the third coiled conductor and the fourth coiled conductor.

(2) A frequency stabilization circuit according to a second illustrative embodiment is **characterized in that** the first coiled conductor, the second coiled conductor, the third coiled conductor, and the fourth coiled conductor are wound so that the direction of a magnetic flux passing through the first closed magnetic circuit and the direction of a magnetic flux passing through the second closed magnetic circuit are opposite to each other.

(3) A frequency stabilization circuit according to a third illustrative embodiment is **characterized in that** the first coiled conductor and the third coiled conductor are magnetically coupled to each other, and the second coiled conductor and the fourth coiled conductor are magnetically coupled to each other.

(4) A frequency stabilization circuit according to a fourth illustrative embodiment is **characterized in that** a capacitor is connected between an antenna port connected to an antenna and ground.

(5) A frequency stabilization circuit according to a fifth illustrative embodiment is **characterized in that** the first coiled conductor, the second coiled conductor, the third coiled conductor, and the fourth coiled conductor are configured by a conductor pattern within a common multilayer substrate.

(6) A frequency stabilization circuit according to a sixth illustrative embodiment is **characterized in that** a winding axis of each of the first coiled conductor, the second coiled conductor, the third coiled conductor, and the fourth coiled conductor is oriented in a lamination direction of the multilayer substrate, individual winding axes of the first coiled conductor and the second coiled conductor are placed side by side in a different relationship, individual winding axes of the third coiled conductor and the fourth coiled conductor are placed side by side in a different relationship, and a winding range of the first coiled conductor and a winding range of the third coiled conductor at least partly overlap with each other in planar view, and a winding range of the second coiled conductor and a winding range of the fourth coiled conductor at least partly overlap with each other in planar view.

(7) A frequency stabilization circuit according to a seventh illustrative embodiment includes at least a first coiled conductor, a second coiled conductor, a third coiled conductor, a fourth coiled conductor, a fifth coiled conductor, and a sixth coiled conductor, wherein the first coiled conductor and the second coiled conductor are connected in series to each other, thereby configuring a first series circuit, the third coiled conductor and the fourth coiled conductor are connected in series to each other, thereby configuring a second series circuit, the fifth coiled conductor and the sixth coiled conductor are connected in series to each other, thereby configuring a third series circuit, the first coiled conductor and the second coiled conductor are wound so that a first closed magnetic circuit is configured on the basis of the first coiled conductor and the second coiled,conductor, the third coiled conductor and the fourth coiled conductor are wound so that a second closed magnetic circuit is configured on the basis of the third coiled conductor and the fourth coiled conductor, the fifth coiled conductor and the sixth coiled conductor are wound so that a third closed magnetic circuit is configured on the basis of the fifth coiled conductor and the sixth coiled conductor, and the second closed magnetic circuit is sandwiched between the first closed magnetic circuit and the third closed magnetic circuit in a layer direction.

(8) A frequency stabilization circuit according to an eighth illustrative embodiment is **characterized in that**
the first coiled conductor, the second coiled conductor, the third coiled conductor, and the fourth coiled conductor are wound so that the direction of a magnetic flux passing through the first closed magnetic circuit and the direction of a magnetic flux passing through the second closed magnetic circuit are opposite to each other, and
the third coiled conductor, the fourth coiled conductor, the fifth coiled conductor, and the sixth coiled conductor are wound so that the direction of a magnetic flux passing through the second closed magnetic circuit and the direction of a magnetic flux passing through the third closed magnetic circuit are opposite to each other.

(9) A frequency stabilization circuit according to a ninth illustrative embodiment is **characterized in that**
the first coiled conductor, the second coiled conductor, the third coiled conductor, and the fourth coiled conductor are wound so that the direction of a magnetic flux passing through the first closed magnetic circuit and the direction of a magnetic flux passing through the second closed magnetic circuit are opposite to each other, and
the third coiled conductor, the fourth coiled conductor, the fifth coiled conductor, and the sixth coiled conductor are wound so that the direction of a magnetic flux passing through the second closed magnetic circuit and the direction of a magnetic flux passing through the third closed magnetic circuit are equal to each other.

(10) An antenna device according to a tenth illustrative embodiment includes
a frequency stabilization circuit including a power feeding port connected to a power feeding circuit and an antenna port connected to an antenna and an antenna connected to the antenna port, wherein the antenna device includes the frequency stabilization circuit in (1).

(11) An antenna device according to an eleventh illustrative embodiment includes
a frequency stabilization circuit including a power feeding port connected to a power feeding circuit and an antenna port connected to an antenna and an antenna connected to the antenna port, wherein the antenna device includes the frequency stabilization circuit in (7).

(12) A communication terminal device according to a twelfth illustrative embodiment includes
a frequency stabilization circuit including a power feeding port connected to a power feeding circuit and an antenna port connected to an antenna, an antenna connected to the antenna port, and a power feeding circuit connected to the power feeding port, wherein the communication terminal device includes the frequency stabilization circuit in (1).

(13) A communication terminal device according to a thirteenth illustrative embodiment includes
a frequency stabilization circuit including a power feeding port connected to a power feeding circuit and an antenna port connected to an antenna, an antenna connected to the antenna port, and a power feeding circuit connected to the power feeding port, wherein the communication terminal device includes the frequency stabilization circuit in (7).

Advantageous Effects of Invention

According to-the present invention, it is possible to stabilize the frequency of a high-frequency signal without being affected by the shape of a radiator or a housing, the placement situation of a neighboring component, or the like.

Brief Description of Drawings

[Fig. 1] Fig. 1(A) is a schematic configuration diagram relating to a frequency stabilization circuit of the present invention, an antenna device including the frequency stabilization circuit, and a mobile communication terminal. Fig. 1(B) is a schematic configuration diagram relating to an antenna device and a mobile communication terminal as a comparative example.

[Fig. 2] Fig. 2 is a circuit diagram of a frequency stabilization circuit 35 that is a comparative example for the frequency stabilization circuit according to the present invention.

[Fig. 3] Fig. 3(A) is an equivalent circuit diagram of the frequency stabilization circuit 35 as the comparative example illustrated in Fig. 2, and Fig. 3(B) is a modified circuit diagram thereof.

[Fig. 4] Fig. 4 is a circuit diagram of a basic form of the frequency stabilization circuit according to the present invention.

[Fig. 5] Fig. 5(A) is an equivalent circuit diagram of the basic form of' the frequency stabilization circuit illustrated in Fig. 4, and Fig. 5(B) is a modified circuit diagram thereof.

[Fig. 6] Fig. 6(A) illustrates a reflection characteristic S11 and a transmission characteristic S21 of the basic form of the frequency stabilization circuit according to the present invention, and Fig. 6(B) illustrates a reflection characteristic S11 and a transmission characteristic S21 of the frequency stabilization circuit of the comparative example.

[Fig. 7] Fig. 7 is a circuit diagram of a frequency stabilization circuit 25 according to a first embodiment.

[Fig. 8] Fig. 8 is a diagram illustrating an example of a conductor pattern of each layer when the frequency stabilization circuit 25 according to the first embodiment is configured in a multilayer substrate.

[Fig. 9] Fig. 9 illustrates a main magnetic flux passing through a coiled conductor based on a conductor pattern formed in each layer of the multilayer substrate illustrated in Fig. 8.

[Fig. 10] Fig. 10 is a diagram illustrating a relationship between magnetic connections of four coiled conductors L1 to L4 in the frequency stabilization circuit 25 according to the first embodiment.

[Fig. 11] Fig. 11 is a diagram in which input impedance defined where a power feeding port is viewed from a power feeding circuit is expressed on a Smith chart when coupling coefficients between the coiled conductors based on the coiled conductors L1 to L4 are set to predetermined values.

[Fig. 12] Fig. 12 is a diagram illustrating inductance matching between a radiator and a power feeding circuit, based on the frequency stabilization circuit indicating negative inductance.

[Fig. 13] Fig. 13 is a diagram illustrating a configuration of a frequency stabilization circuit according to a second embodiment, and a diagram illustrating an example of a conductor pattern of each layer when the frequency stabilization circuit is configured in a multilayer substrate.

[Fig. 14] Fig. 14 a diagram illustrating a main magnetic flux passing through a coiled conductor based on a conductor pattern formed in each layer of the multilayer substrate illustrated in Fig. 13.

[Fig. 15] Fig. 15 is a diagram illustrating a relationship between magnetic connections of four coiled conductors L1 to L4 in the frequency stabilization circuit according to the second embodiment.

[Fig. 16] Fig. 16 is a circuit diagram of a frequency stabilization circuit 25A according to a third embodiment.

[Fig. 17] Fig. 17(A) is a diagram illustrating a reflection characteristic of a frequency stabilization circuit, and Fig. 17 (B) is a diagram illustrating a reflection characteristic in a state in which a capacitor is connected to an antenna port of the frequency stabilization circuit.

[Fig. 18] Fig. 18(A) is an impedance locus of a radiator. Fig. 18(B) is a diagram illustrating a reflection characteristic in a state in which a capacitor is connected to an antenna port of a frequency stabilization circuit.

[Fig. 19] Fig. 19(A) is an impedance locus viewed from a power feeding port of the frequency stabilization circuit in a state in which a radiator having the characteristic illustrated in Fig. 18 is connected to the frequency stabilization circuit according to the third embodiment. Fig. 19(B) is a frequency characteristic diagram relating to a reflection characteristic S11 and a transmission characteristic S21 viewed from the power feeding port of the frequency stabilization circuit.

[Fig. 20] Fig. 20 is a diagram illustrating an example of a conductor pattern of each layer of a frequency stabilization circuit according to a fourth embodiment configured in a multilayer substrate.

[Fig. 21] Fig. 21 is a diagram illustrating a relationship between magnetic connections of four coiled conductors L1 to L4 in the frequency stabilization circuit according to the fourth embodiment.

[Fig. 22] Fig. 22 is a diagram illustrating a frequency characteristic of the frequency stabilization circuit 35 as the comparative example illustrated in Fig. 2.

[Fig. 23] Fig. 23 is a diagram illustrating a frequency characteristic of the frequency stabilization circuit 25A illustrated in the third embodiment.

[Fig. 24] Fig. 24 is a circuit diagram of a frequency stabilization circuit according to a fifth embodiment.

[Fig. 25] Fig. 25 is a diagram illustrating an example of a conductor pattern of each layer when the frequency stabilization circuit according to the fifth embodiment is configured in a multilayer substrate.

[Fig. 26] Fig. 26 is a diagram illustrating a frequency characteristic of the frequency stabilization circuit illustrated in the fifth embodiment.

[Fig. 27] Fig. 27(A) is a diagram illustrating a reflection characteristic of the frequency stabilization circuit 35 as the comparative example illustrated in Fig. 2. Fig. 27(B) is a diagram illustrating a reflection characteristic of the frequency stabilization circuit 25A illustrated in the third embodiment. Fig. 27(C) is a diagram illustrating a reflection characteristic of the frequency stabilization circuit according to the fifth embodiment.

[Fig. 28] Fig. 28 is a circuit diagram of a frequency stabilization circuit according to a sixth embodiment.

[Fig. 29] Fig. 29 is a diagram illustrating an example of a conductor pattern of each layer when the frequency stabilization circuit according to the sixth embodiment is configured in a multilayer substrate.

[Fig. 30] Fig. 30 is a circuit diagram of a frequency stabilization circuit according to a seventh embodiment.

[Fig. 31] Fig. 31 is a diagram illustrating an example of a conductor pattern of each layer when the frequency stabilization circuit according to the seventh embodiment is configured in a multilayer substrate.

Description of Embodiments

Before the specific embodiment of a frequency stabilization circuit of the present invention is illustrated, an object and a function effect of the frequency stabilization circuit of the present invention will be described.

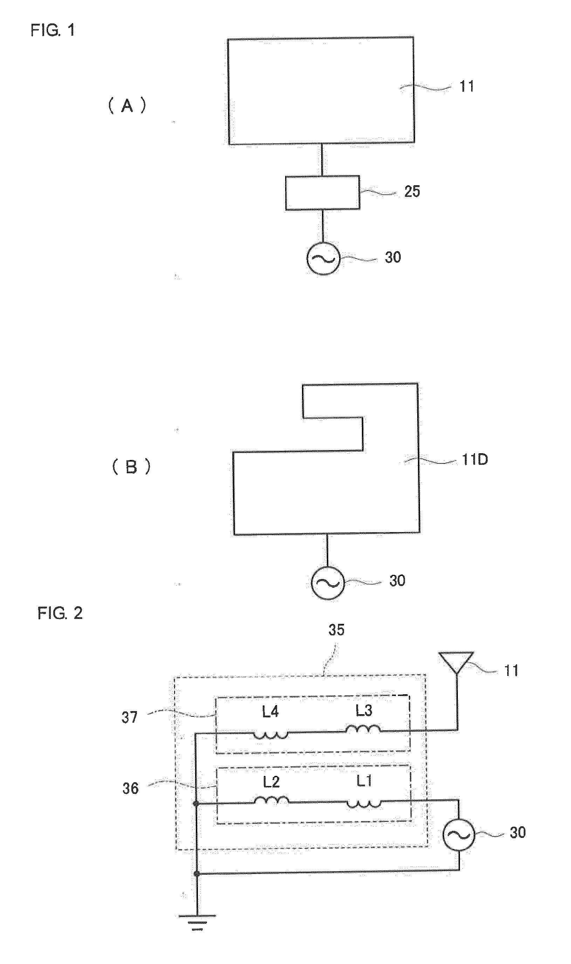

Fig. 1(A) is a schematic configuration diagram relating to the frequency stabilization circuit of the present invention, an antenna device including the frequency stabilization circuit, and a mobile communication terminal. Fig. 1 (B) is a schematic configuration diagram relating to an antenna device and a mobile communication terminal as a comparative example.

Fig. 1(B) illustrates the configuration of a radiator 11D to which a power feeding circuit 30 feeds power. In an antenna design method of the related art, there has been a design constraint that an external appearance design of a product is determined first and it is necessary to design a radiator 11 so the the radiator 11 fits therein. There are two objects when an antenna is designed, as follows.

(1) To enhance a radiation efficiency. To cause as much electric power as possible to be radiated into a space.
(2) To perform frequency adjustment. To establish matching for inputting electric power to an antenna.

However, when an antenna fitting in the housing of an integration destination whose size and shape are limited is designed, there is frequently a trade-off relationship between the radiation efficiency and frequency adjustment of the above-mentioned antenna.

A frequency stabilization circuit 25 according to the present invention, illustrated in Fig. 1(A), includes a power feeding port and an antenna port, a power feeding circuit 30 is connected to the power feeding port, and the radiator 11 is connected to the antenna port. Using the frequency stabilization circuit 25 and the radiator 11, an antenna device is configured. Furthermore, using a circuit including the antenna device and the power feeding circuit 30, a mobile communication terminal is configured.

Using the frequency stabilization circuit 25 of the present invention, the radiator has a simple shape so that capacitive coupling between radiators and capacitive coupling between the radiator and the ground are reduced, and only specializes in enhancing a radiation efficiency, and frequency adjustment is entrusted to the frequency stabilization circuit 25. Accordingly, it becomes quite easy to design an antenna without being subjected to the above-mentioned trade-off relationship, and a development period is also greatly reduced.

Fig. 2 is the circuit diagram of a frequency stabilization circuit 35 that is a comparative example for the frequency stabilization circuit according to the present invention. The frequency stabilization circuit 35 includes a primary-side series circuit 36 connected to the power feeding circuit 30 and a secondary-side series circuit 37 electromagnetic-field-coupled to the primary-side series circuit. The primary-side series circuit 36 is a series circuit including a first coiled conductor L1 and a second coiled conductor L2, and the secondary-side series circuit 37 is a series circuit including a third coiled conductor L3 and a fourth coiled conductor L4.

One end portion of the primary-side series circuit 36 is connected to the power feeding circuit 30, and one end portion of the secondary-side series circuit 37 is connected to the radiator 11. The other end portion of the primary-side series circuit 36 and the other end portion of the secondary-side series circuit 37 are connected to the ground.

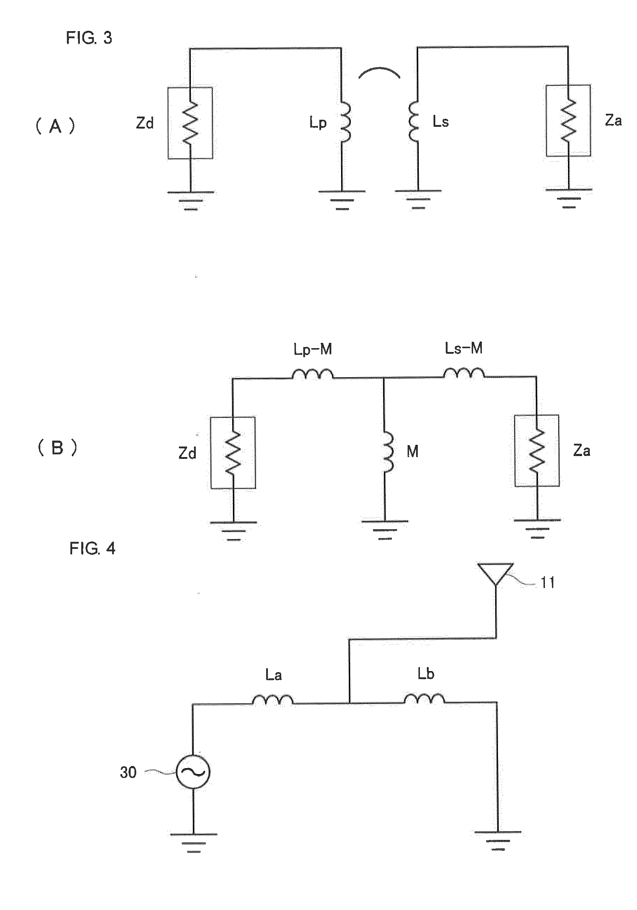

Fig. 3(A) is the equivalent circuit diagram of the frequency stabilization circuit 35 as the comparative example illustrated in Fig. 2, and Fig. 3(B) is the modified circuit diagram thereof. Here, an inductor Lp indicates the inductance of the primary-side series circuit, an inductor Ls indicates the inductance of the secondary-side series circuit, and an inductor M indicates mutual inductance. When a coupling coefficient between Lp and Ls is expressed by k, a relationship $M = k * \sqrt{(Lp * Ls)}$ is satisfied. Impedance Zd is the impedance of the power feeding circuit 30, and impedance Za is the impedance of the radiator 11.

Fig. 4 is the circuit diagram of the basic form of the frequency stabilization circuit according to the present invention. An inductor La is connected between the power feeding circuit 30 and the radiator 11, and an inductor Lb is connected between the radiator 11 and the ground.

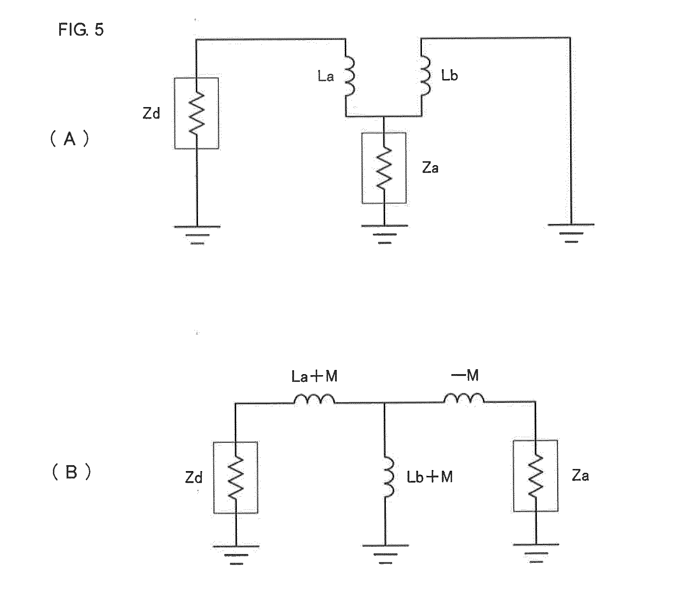

Fig. 5 (A) is the equivalent circuit diagram of the basic form of the frequency stabilization circuit illustrated in Fig. 4, and Fig. 5 (B) is the modified circuit diagram thereof.

In the frequency stabilization circuit of the comparative example, illustrated in Fig. 2, a transformer unit is configured using the primary-side series circuit 36 and the secondary-side series circuit 37. When being expressed using the equivalent circuit illustrated in Fig. 3, an impedance conversion ratio based on the transformer unit turns out to be Lp : Ls.

On the other hand, in the basic form of the frequency stabilization circuit of the present invention, illustrated in Fig. 4, as an equivalent circuit illustrated in Fig. 5(B), the impedance conversion ratio turns out to be

$$(La + M + Lb + M) : (- M + Lb + M) = (La + Lb + 2 * M) : Lb.$$

When a coupling coefficient between La and Lb is expressed by k, a mutual inductance M satisfies a relationship $M = k * \sqrt{(La * Lb)}$. When the mutual inductance M is increased, a large impedance conversion ratio is obtained compared with the frequency stabilization circuit of the comparative example. Therefore, compared with the frequency stabilization circuit of the comparative example, it is possible to reduce the value of the inductor La of a power feeding circuit side. In addition, since an inductance between the power feeding circuit 30 and the ground, illustrated in Fig. 4, becomes La + Lb + 2 * M, there is also obtained an advantage that it hardly appears to be "shorted" to the ground even if La is small. Accordingly, it is possible to reduce the inductance value of the inductor La, and hence it is possible to perform downsizing and it is possible to achieve low loss. In this way, the frequency stabilization circuit functions as an impedance converter circuit.

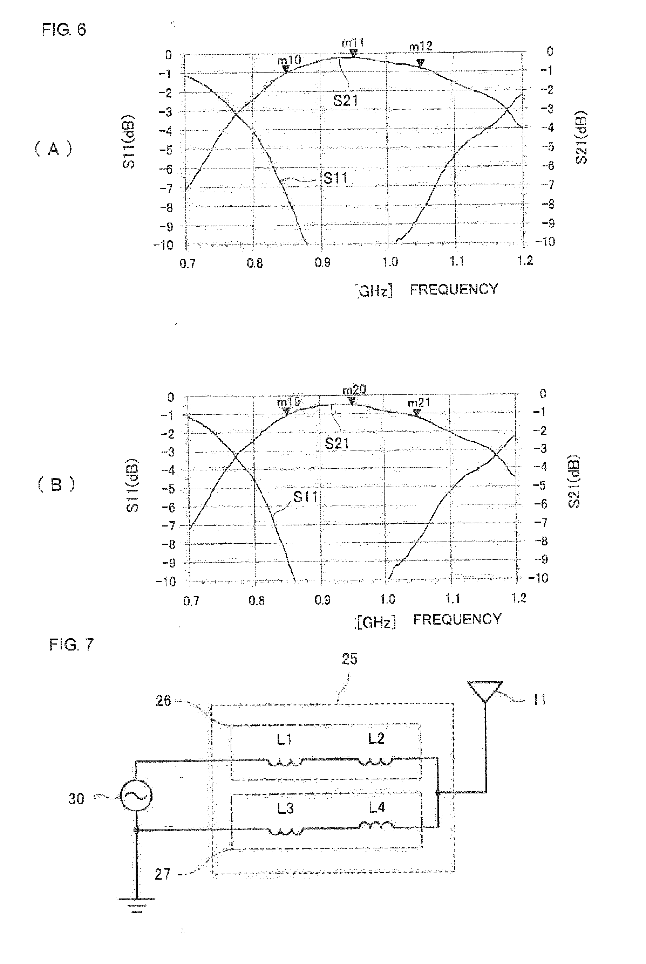

Fig. 6(A) illustrates the reflection characteristic S11 and the transmission characteristic S21 of the basic form of the frequency stabilization circuit according to the present invention (refer to Fig. 4), and Fig. 6(B) illustrates the reflection characteristic S11 and the transmission characteristic S21 of the frequency stabilization circuit of the comparative example. While necessary inductors are Lp = 25 nH and Ls = 8.7 nH in the comparative example, necessary inductors are La = 5.6 nH and Lb = 13 nH in the basic form of the frequency stabilization circuit of the present invention. Since matching is established using small inductances in this way, it is possible to diminish a structure. Therefore, a loss due to a conductor pattern is reduced, and a transmission loss is diminished. Here, if the Q value of an inductor is 75, it is possible to obtain the improvement of about 12.5% with respect to the transmission loss.

In addition, since it is not necessary to increase the value of a necessary inductor, the self-resonance frequency of the transformer unit becomes high in addition to the reduction of cost. Namely, while the self-resonance frequency of the transformer unit is determined on the basis of $2 * \pi * \sqrt{(1 / (L * C))}$, the self-resonance frequency increases owing to the reduction of L. Since, at the self-resonance frequency, energy is confined and the transformer unit does not function as a transformer, a frequency band in which the transformer unit functions as the transformer is expanded owing to the increase of the self-resonance frequency.

«First Embodiment»

Fig. 7 is the circuit diagram of the frequency stabilization circuit 25 according to a first embodiment. The frequency stabilization circuit 25 includes a first series circuit 26 connected to the power feeding circuit 30 and a second series circuit 27 electromagnetic-field-coupled to the first series circuit 26. The first series circuit 26 is a series circuit including a first coiled conductor L1 and a second coiled conductor L2, and the second series circuit 27 is a series circuit including a third coiled conductor L3 and a fourth coiled conductor L2 The first series circuit 26 is connected between an antenna port and a power feeding port, and the second series circuit 27 is connected between the antenna port and the ground.

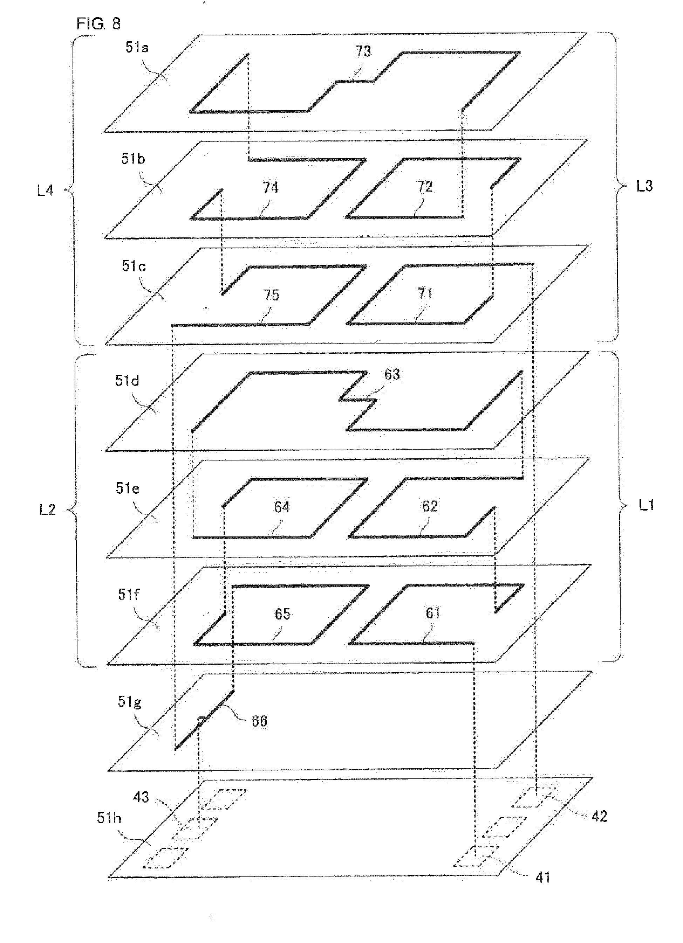

Fig. 8 is a diagram illustrating an example of a conductor pattern of each layer when the frequency stabilization circuit 25 according to the first embodiment is configured in a multilayer substrate. While each layer includes a magnetic sheet and the conductor pattern of each layer is formed on the back surface of the magnetic sheet in a direction illustrated in Fig. 8, each conductor pattern is indicated by a solid line. In addition, while a linear conductor pattern has a predetermined line width, the linear conductor pattern is indicated by a simple solid line, here.

In a range illustrated in Fig. 8, a conductor pattern 73 is formed on the back surface of a first layer 51a, conductor patterns 72 and 74 are formed on the back surface of a second layer 51b, and conductor patterns 71 and 75 are formed on the back surface of a third layer 51c. A conductor pattern' 63 is formed on the back surface of a fourth layer 51d, conductor patterns 62 and 64 are formed on the back surface of a fifth layer 51e, and conductor patterns 61 and 65 are formed on the back surface of a sixth layer 51f. A conductor pattern 66 is formed on the back surface of a seventh layer 51g, and a power feeding terminal 41, a ground terminal 42, and an antenna terminal 43 are formed on the back surface of an eighth layer 51h. Dashed lines extending in a longitudinal direction in Fig. 8 are via electrodes, and connect conductor patterns to one another through interlayers. While actually these via electrodes are pillar-shaped electrodes having a predetermined diameter dimension, these via electrodes are indicated by simple dashed lines, here.

In Fig. 8, the first coiled conductor L1 is configured using the right half of the conductor pattern 63 and the conductor patterns 61 and 62. In addition, the second coiled conductor L2 is configured using the left half of the conductor pattern 63 and the conductor patterns 64 and 65. In addition, the third coiled conductor L3 is configured using the right half of the conductor pattern 73 and the conductor patterns 71 and 72. In addition, the fourth coiled conductor L4 is configured using the left half of the conductor pattern 73 and the conductor patterns 74 and 75. The winding axes of the individual coiled conductors L1 to L4 are oriented in the lamination direction of the multilayer substrate. In addition, the winding axes of the first coiled conductor L1 and the second coiled conductor L2 are placed side by side in a different relationship. In the same way, the individual winding axes of the third coiled conductor L3 and the fourth coiled conductor L4 are placed side by side in a different relationship. In addition, the winding range of the first coiled conductor L1 and the winding range of the third coiled conductor L3 at least partly overlap with each other in planar view, and the winding range of the second coiled conductor L2 and the winding range of the fourth coiled conductor L4 at least partly overlap with each other in planar view. In this example, these winding ranges overlap with each other almost completely. In this way, using conductor pattern having figure-of-eight structures, four coiled conductor are configured. In addition, it is only necessary for each coiled conductor to include at least one looped conductor, and a coiled conductor may also be adopted in which a looped conductor is wound a plurality of turns on one plain surface. In addition to this, a coiled conductor may also be adopted in which looped conductors of one turn or a plurality of turns are laminated in a plurality of layers.

In addition, each layer may be configured using a dielectric sheet. In this regard, however, if a magnetic sheet whose relative permeability is high is used, it is possible to enhance a coupling coefficient between coiled conductors.

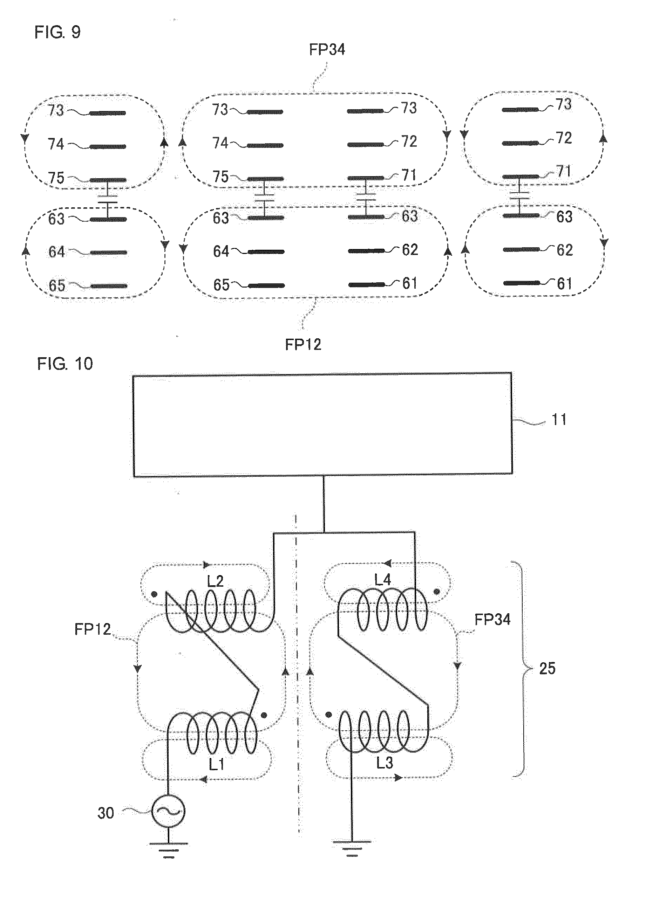

Fig. 9 illustrates a main magnetic flux passing through a coiled conductor based on a conductor pattern formed in each layer of the multilayer substrate illustrated in Fig. 8. A magnetic flux FP12 passes through the first coiled conductor L1 based on the conductor patterns 61 to 63 and the second coiled conductor L2 based on the conductor patterns 63 to 65. In addition, a magnetic flux FP34 passes through the third coiled conductor L3 based on the conductor patterns 71 to 73 and the fourth coiled conductor L4 based on the conductor patterns 73 to 75. In addition, the looped conductor patterns 75 and 63 are coupled to each other and the looped conductor patterns 71 and 63 are coupled to each other, through capacitances. Namely, these coiled conductors L1 and L3 are coupled to each other and these coiled conductors L2 and L4 are coupled to each other, through magnetic fields and electric fields. Accordingly, for example, when a current flows through L1, an induced current and a current due to electric field coupling are induced in L3, and furthermore, since L1 and L3 are wound in directions opposite to each other, the induced current and the current due to electric field coupling flow in the same direction and an energy transmission efficiency is improved. A relationship between the coiled conductors L2 and L4 is also the same.

Fig. 10 is a diagram illustrating a relationship between magnetic connections of the four coiled conductors L1 to L4 in the frequency stabilization circuit 25 according to the first embodiment. In this way, the first coiled conductor L1 and the second coiled conductor L2 are wound so that a first closed magnetic circuit (a loop indicated by the magnetic flux FP12) is configured owing to the first coiled conductor L1 and the second coiled conductor L2, and the third coiled conductor L3 and the fourth coiled conductor L4 are wound so that a second closed magnetic circuit (a loop indicated by the magnetic flux FP34) is configured owing to the third coiled conductor L3 and the fourth coiled conductor L4. In this way, the four coiled conductors L1 to L4 are wound so that the direction of the magnetic flux FP12 passing through the first closed magnetic circuit and the direction of the magnetic flux FP34 passing through the second closed magnetic circuit are opposite to each other. A straight line of a two-dot chain line in Fig. 10 indicates a magnetic barrier preventing the two magnetic fluxes FP12 and FP34 from being coupled to each other. In this way, the magnetic barrier occurs between the coiled conductors L1 and L3 and between the coiled conductors L2 and L4.

Next, the function effect of the frequency stabilization circuit 25 according to the first embodiment will be illustrated. The main roles of the frequency stabilization circuit 25 are the following two roles.

(1) For example, the impedance of an antenna is reduced to about 3 to 20 Ω with a decrease in the size of the antenna. The frequency stabilization circuit establishes the matching of the real part R of the impedance using the transformer function thereof.

(2) Since basically the radiator has an inductance property, the frequency characteristic of impedance has an upward-sloping characteristic. On the other hand, the frequency stabilization circuit functions as negative inductance, and the slope of the impedance (jx) of the antenna is attenuated by combining the frequency stabilization circuit with the radiator.

A point that the frequency stabilization circuit functions as the negative inductance will be described hereinafter.

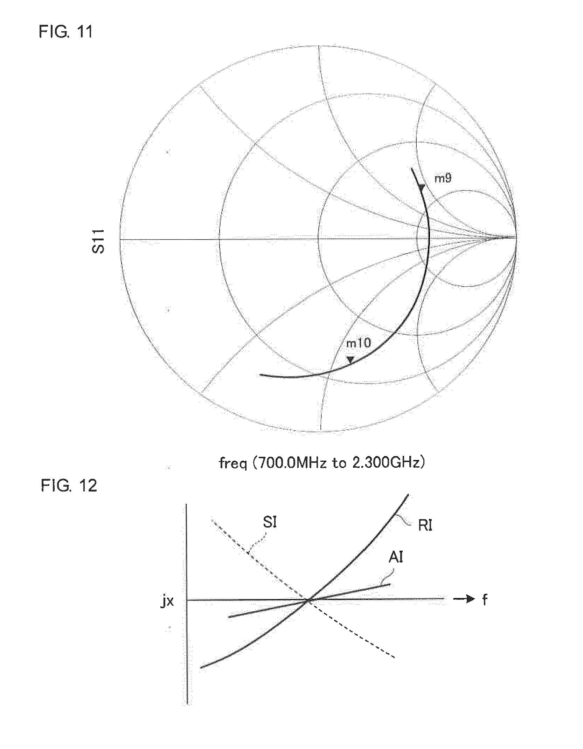

Fig. 11 is a diagram in which a reflection characteristic defined where the power feeding port is viewed from a power feeding circuit is expressed on a Smith chart when coupling coefficients between the coiled conductors based on the above-mentioned coiled conductors L1 to L4 are set to predetermined values. Here, individual coupling coefficients are as follows.

$$L1\text{-}L2:\ k \approx 0,3$$

$$L3\text{-}L4:\ k \approx 0.3$$

$$L1\text{-}L3:\ k \approx 0.8$$

$$L2\text{-}L4:\ k \approx 0.8$$

In this way, L1 and L3 are strongly coupled to each other and L2 and L4 are strongly coupled to each other (k = about 0.8), and L1 and L2 are weakly coupled to each other and L3 and L4 are weakly coupled to each other (k = about 0.3). Therefore, the effective values of L1, L2, L3, and L4 become small with maintaining the mutual inductance M occurring owing to coupling at a large value. Therefore, the coupling coefficient equivalently becomes greater than or equal to "1", and the impedance of the frequency stabilization circuit turns out to appear to be the negative inductance. Namely, it is possible to form a metamaterial structure.

In addition, while the coupling between L1 and L2 and the coupling between L3 and L4 (coupling between coiled conductors in a horizontal direction) individually become magnetic field coupling in which the inductance values thereof become small, since the coupling between coiled conductors in the horizontal direction does not affect the coupling between L1 and L3 and the coupling between L2 and L4 (coupling between coiled conductors in a longitudinal direction), it may be estimated that such a new advantageous effect occurs.

In Fig. 11, a marker m9 is an input impedance (S(1, 1) = 0.358 + j0.063 at a frequency 820 MHz, and a marker m10 is an input impedance (S(1, 1) = 0.382 - J0.059) at a frequency 1.99 GHz. In this way, an induction property occurs in a band whose frequency is low and a capacitive property occurs in a band whose frequency is high, and a negative inductance is obtained where a real number component (resistance component) continuously changes.

Fig. 12 is a.diagram illustrating inductance matching between the radiator and the power feeding circuit, based on the frequency stabilization circuit indicating the above-mentioned negative inductance. In Fig. 12, a horizontal axis is a frequency, and a vertical axis is reactance jx. The radiator in itself includes an inductance, and includes a capacitance with respect to the ground. Therefore, the impedance jxa of the radiator is expressed by jxa = ωL - 1 / (ωC. A curved line RI in Fig. 12 indicates the impedance jxa of the radiator. The resonance frequency of the radiator is a frequency where jxa = 0. On the other hand, since the impedance of the frequency stabilization circuit is a negative inductance, the impedance of the frequency stabilization circuit is expressed by a downward-sloping characteristic as indicated by a curved line (straight line) SI. Accordingly, the impedance of the antenna device (impedance viewed from the power feeding port), based on the frequency stabilization circuit and the radiator, has a frequency characteristic whose slope is small as indicated by a curved line (straight line) AI.

Here, when the real part of the impedance of the radiator at a point deviating from the resonance frequency is expressed by R and a frequency satisfying a relationship jx = R is f1, the frequency f1 is a frequency (dropping by 3 dB) where one half of input electric power is reflected and the other half thereof is radiated. Therefore, if "- R" is assumed and a frequency where jx = - R is f2, a frequency width extending from the frequency f2 to the frequency f1 can be defined as the bandwidth (full width at half maximum) of the antenna.

When the slope of the impedance of the antenna device including the frequency stabilization circuit and the radiator is attenuated, a frequency where jx = R becomes higher than the above-mentioned f1, and a frequency where jx = - R becomes lower than the above-mentioned f2. Therefore, the bandwidth (frequency band dropping by 3 dB) of the antenna is widened. Namely, impedance matching turns out to be established over a wide band. This is an advantageous effect due to the negative inductance.

«second Embodiment»

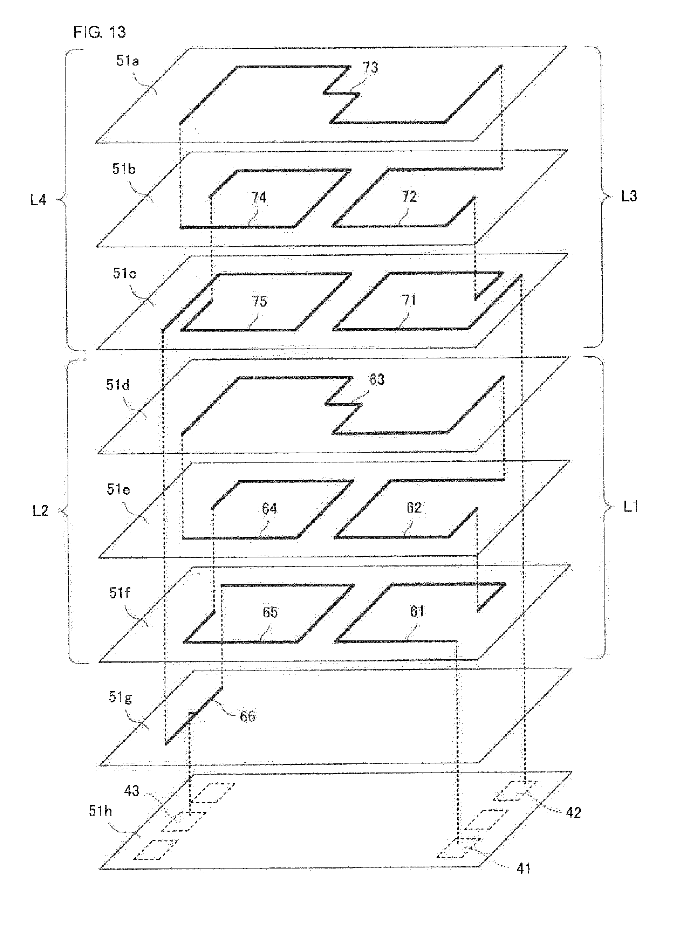

Fig. 13 is a diagram illustrating the configuration of a frequency stabilization circuit according to a second embodiment, and a. diagram illustrating an example of the conductor pattern of each layer when the frequency stabilization circuit is configured in a multilayer substrate. While the conductor pattern of each layer is formed on the back surface in a direction illustrated in Fig. 13, each conductor pattern is indicated by a solid line. In addition, while a linear conductor pattern has a predetermined line width, the linear conductor pattern is indicated by a simple solid line, here.

In a range illustrated in Fig. 13, a conductor pattern 73 is formed on the back surface of a first layer 51a, conductor patterns 72 and 74 are formed on the back surface of a second layer 51b, and conductor patterns 71 and 75 are formed on the back surface of a third layer 51c. A conductor pattern 63 is formed on the back surface of a fourth layer 51d, conductor patterns 62 and 64 are formed on the back surface of a fifth layer 51e, and conductor patterns 61 and 65 are formed on the back surface of a sixth layer 51f. A conductor pattern 66 is formed on the back surface of a seventh layer 51g, and a power feeding terminal 41, a ground terminal 42, and an antenna terminal 43 are formed on the back surface of an eighth layer 51h. Dashed lines extending in a longitudinal direction in Fig. 13 are via electrodes, and connect conductor patterns to one another through interlayers. While actually these via electrodes are pillar-shaped electrodes having a predetermined diameter dimension, these via electrodes are indicated by simple dashed lines, here.

In Fig. 13, the first coiled conductor L1 is configured using the right half of the conductor pattern 63 and the conductor patterns 61 and 62. In addition, the second coiled conductor L2 is configured using the left half of the conductor pattern 63 and the conductor patterns 64 and 65. In addition, the third coiled conductor L3 is configured using the right half of the conductor pattern 73 and the conductor patterns 71 and 72. In addition, the fourth coiled conductor L4 is configured using the left half of the conductor pattern 73 and the conductor patterns 74 and 75.

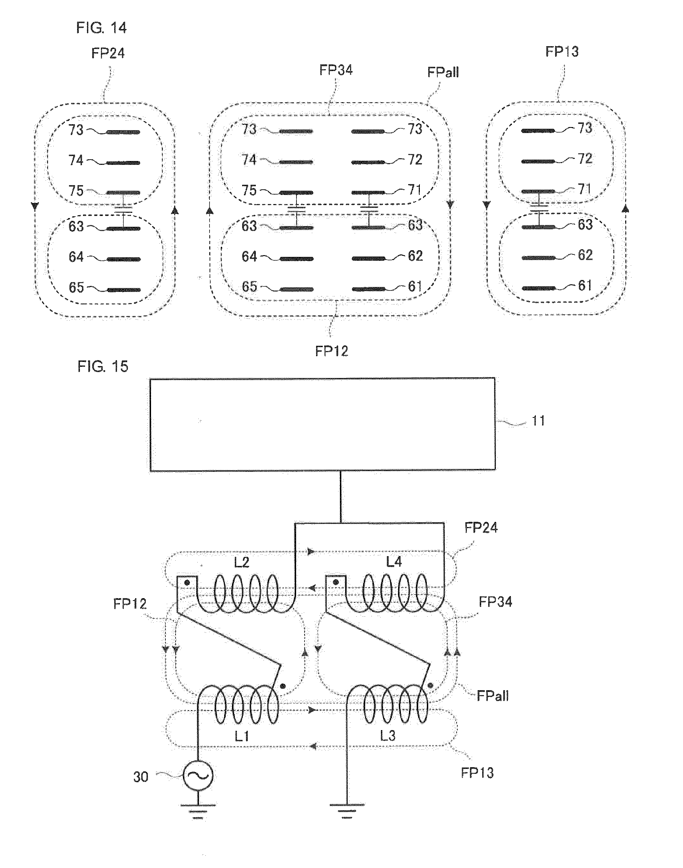

Fig. 14 a diagram illustrating a main magnetic flux passing through a coiled conductor based on a conductor pattern formed in each layer of the multilayer substrate illustrated in Fig. 13. In addition, Fig. 15 is a diagram illustrating a relationship between magnetic connections of four coiled conductors L1 to L4 in the frequency stabilization circuit according to the second embodiment. As illustrated by a magnetic flux FP12, a closed magnetic circuit based on the first coiled conductor L1 and the second coiled conductor L2 is configured, and as illustrated by a magnetic flux FP34, a closed magnetic circuit based on the third coiled conductor L3 and the fourth coiled conductor L4 is configured. In addition, as illustrated by a magnetic flux FP13, a closed magnetic circuit based on the first coiled conductor L1 and the third coiled conductor L3 is configured, and as illustrated by a magnetic flux FP24, a closed magnetic circuit based on the second coiled conductor L2 and the fourth coiled conductor L4 is configured. Furthermore, a closed magnetic circuit FPall based on the four coiled conductors L1 to L4 is also configured.

Also according to the configuration of the second embodiment, since an inductance value between the coiled conductors L1 and L2 and an inductance value between the coiled conductors L3 and L4 become small owing to the individual coupling therebetween, the frequency stabilization circuit illustrated in the second embodiment also obtains the same advantageous effect as the frequency stabilization circuit 25 in the first embodiment.

«Third Embodiment»

In a third embodiment, an example will be illustrated in which an additional circuit is provided in the antenna port of the frequency stabilization circuit illustrated in the first or second embodiment.

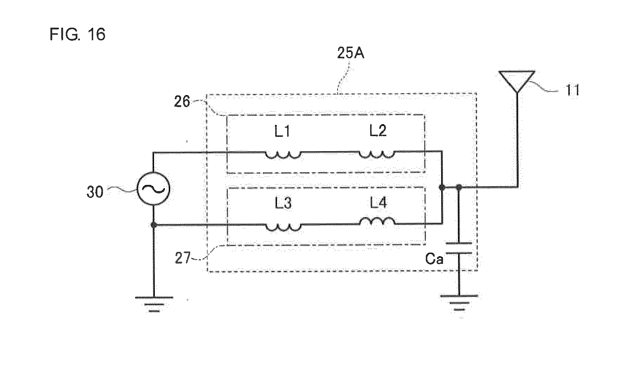

Fig. 16 is the circuit diagram of a frequency stabilization circuit 25A according to the third embodiment. The frequency stabilization circuit 25A includes the first series circuit 26 connected to the power feeding circuit 30 and the second series circuit 27 electromagnetic-field-coupled to the first series circuit 26. The first series circuit 26 is a series circuit including the first coiled conductor L1 and the second coiled conductor L2, and the second series circuit 27 is a series circuit including the third coiled conductor L3 and the fourth coiled conductor L4. The first series circuit 26 is connected between an antenna port and a power feeding port, and the second series circuit 27 is connected between the antenna port and the ground. In addition, a capacitor Ca is connected between the antenna port and the ground.

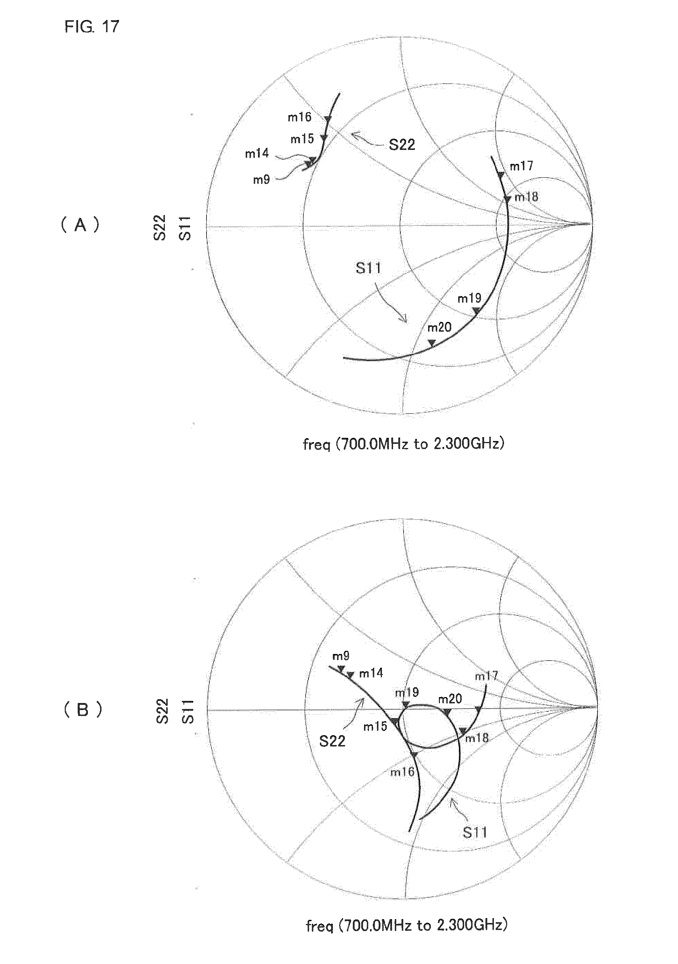

Fig. 17(A) is a diagram illustrating the reflection characteristic of the frequency stabilization circuit illustrated in the first embodiment, and Fig. 17(B) is a diagram illustrating a reflection characteristic in a state in which a capacitor of a predetermined capacitance is connected to the antenna port of the frequency stabilization circuit. Here, a locus when a frequency is swept from 700 MHz to 2.30 GHz is indicated on a Smith chart. A reflection characteristic S11 is the locus of the reflection characteristic from the power feeding port, and a reflection characteristic S22 is the locus of the reflection characteristic from the antenna port. Here, a correspondence relationship between each marker and a frequency is as follows.

(m9, m17) : 824.0 MHz
(m14, m18): 960.0 MHz

(m15, m19) : 1.710 GHz
(m16, m20): 1.990 GHz

When a capacitor of a predetermined capacitance is connected in shunt to the antenna port of the frequency stabilization circuit, the locus of the reflection characteristic S22 when the antenna port of the frequency stabilization circuit is viewed moves on the equivalent conductance curve of the Smith chart, and changes from a state illustrated in Fig. 17(A) to a state illustrated in Fig. 17(B). Namely, in association with an increase in a frequency, the locus is drawn from an induction property to a capacitive property (from the upper semicircle of the Smith chart to the lower semicircle direction thereof). In this way, the negative inductance characteristic of the frequency stabilization circuit becomes clear.

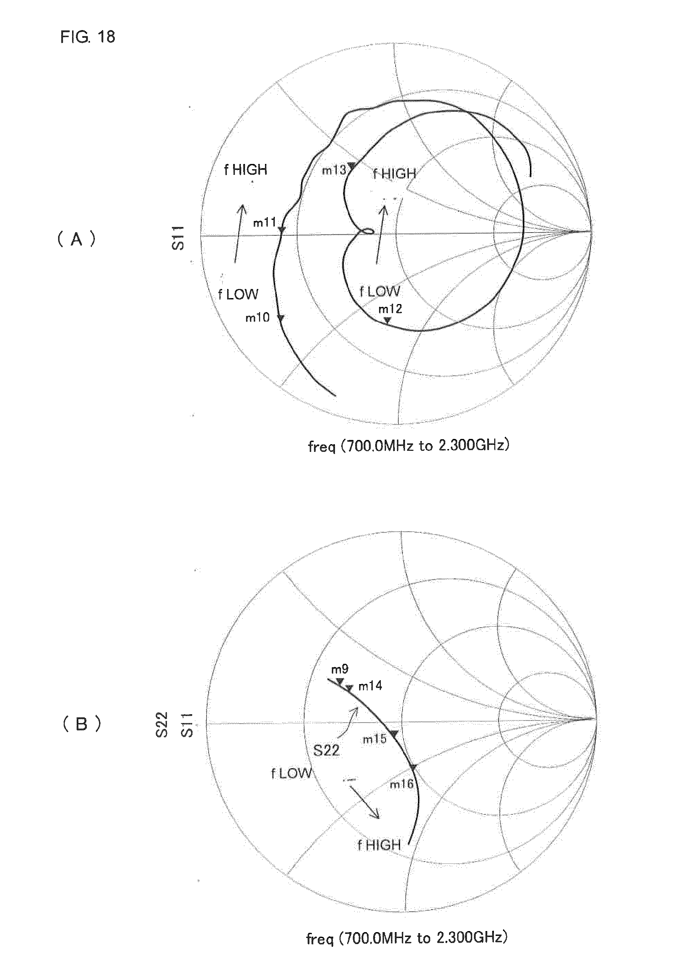

Fig. 18(A) is the impedance locus of a radiator. Here, a correspondence relationship between each marker and a frequency is as follows.

m10: 824.0 MHz
m11: 960.0 MHz
m12: 1.710 GHz
m13: 1.990 GHz

Fig. 18 (B) is a diagram illustrating the reflection characteristic (S22) in a state in which a capacitor of a predetermined capacitance is connected to the antenna port of the frequency stabilization circuit. This drawing is the same as that illustrated in Fig. 17(B). As is clear when Fig. 18(A) is compared with Fig. 18(B), in association with an increase in a frequency, the impedance of the radiator moves in a right upper direction, and the impedance of the frequency stabilization circuit moves in a right lower direction.

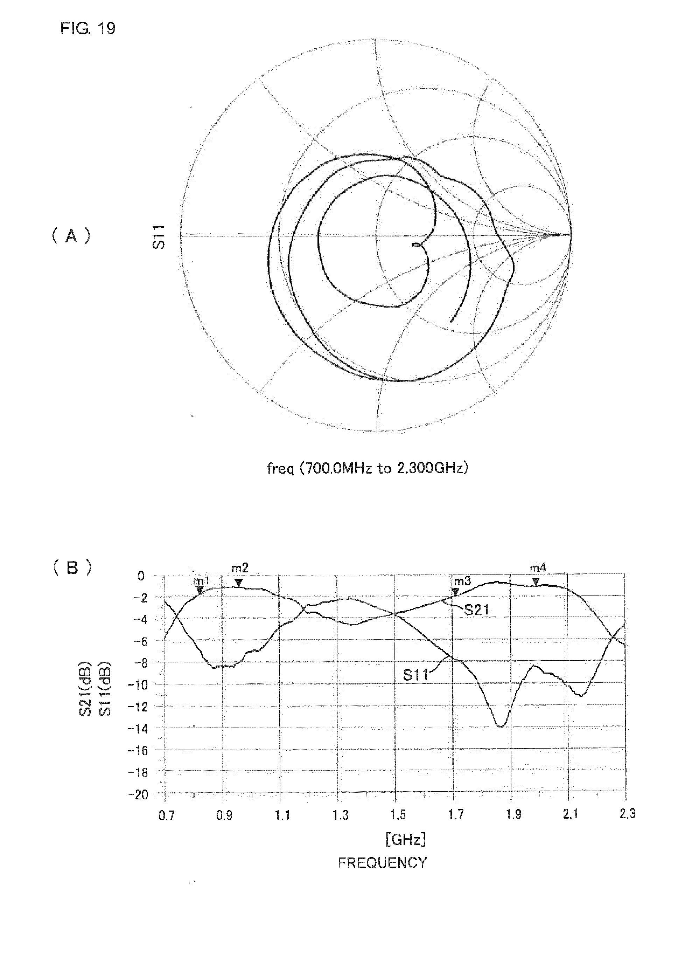

Fig. 19(A) is an impedance locus viewed from the power feeding port of the frequency stabilization circuit in a state in which a radiator having the characteristic illustrated in Fig. 18 is connected to the frequency stabilization circuit according to the third embodiment. In addition, Fig. 19(B) is a frequency characteristic diagram relating to the reflection characteristic S11 and the transmission characteristic S21 viewed from the power feeding port of the frequency stabilization circuit.

In this way, the frequency stabilization circuit whose impedance moves in the right lower direction in association with an increase in a frequency is connected to the radiator whose impedance moves in the right upper direction in association with an increase in a frequency, and hence the impedance viewed from the power feeding port of the frequency stabilization circuit goes around the vicinity of the center of the Smith chart. Namely, it is understood that impedance matching is established over a wide frequency band (700 MHz to 2.3 GHz).

«Fourth Embodiment»

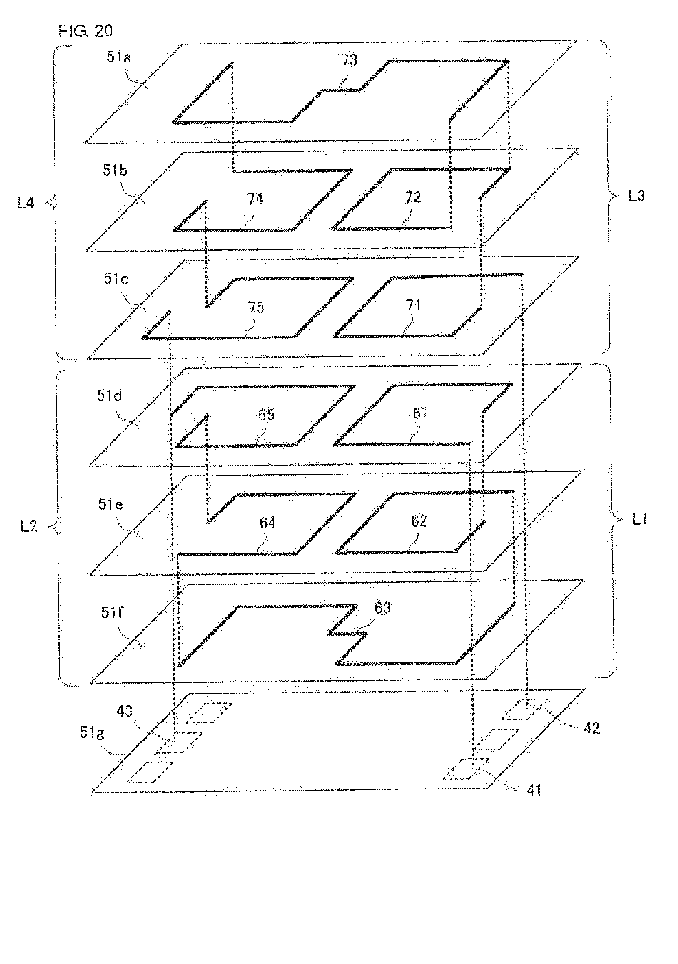

Fig. 20 is a diagram illustrating an example of the conductor pattern of each layer of a frequency stabilization circuit according to a fourth embodiment configured in a multilayer substrate. While each layer includes a magnetic sheet and the conductor pattern of each layer is formed on the back surface of the magnetic sheet in a direction illustrated in Fig. 20, each conductor pattern is indicated by a solid line. In addition, while a linear conductor pattern has a predetermined line width, the linear conductor pattern is indicated by a simple solid line, here.

In a range illustrated in Fig. 20, a conductor pattern 73 is formed on the back surface of a first layer 51a, conductor patterns 72 and 74 are formed on the back surface of a second layer 51b, and conductor patterns 71 and 75 are formed on the back surface of a third layer 51c. Conductor patterns 61 and 65 are formed on the back surface of a fourth layer 51d, conductor patterns 62 and 64 are formed on the back surface of a fifth layer 51e, and a conductor pattern 63 is formed on the back surface of a sixth layer 51f. A power feeding terminal 41, a ground terminal 42, and an antenna terminal 43 are formed on the back surface of a seventh layer 51g. Dashed lines extending in a longitudinal direction in Fig. 20 are via electrodes, and connect conductor patterns to one another through interlayers. While actually these via electrodes pillar-shape electrodes having a predetermined diameter dimension, these via electrodes are indicated by simple dashed lines, here.

In Fig. 20, the first coiled conductor L1 is configured using the right half of the conductor pattern 63 and The conductor patterns 61 and 62. In addition, the second coiled conductor L2 is configured using the left half of the conductor pattern 63 and the conductor patterns 64 and 65. In addition, the third coiled conductor L3 is configured using the right half of the conductor pattern 73 and the conductor patterns 71 and 72. In addition, the fourth coiled conductor L4 is configured using the left half of the conductor pattern 73 and the conductor patterns 74 and 75.

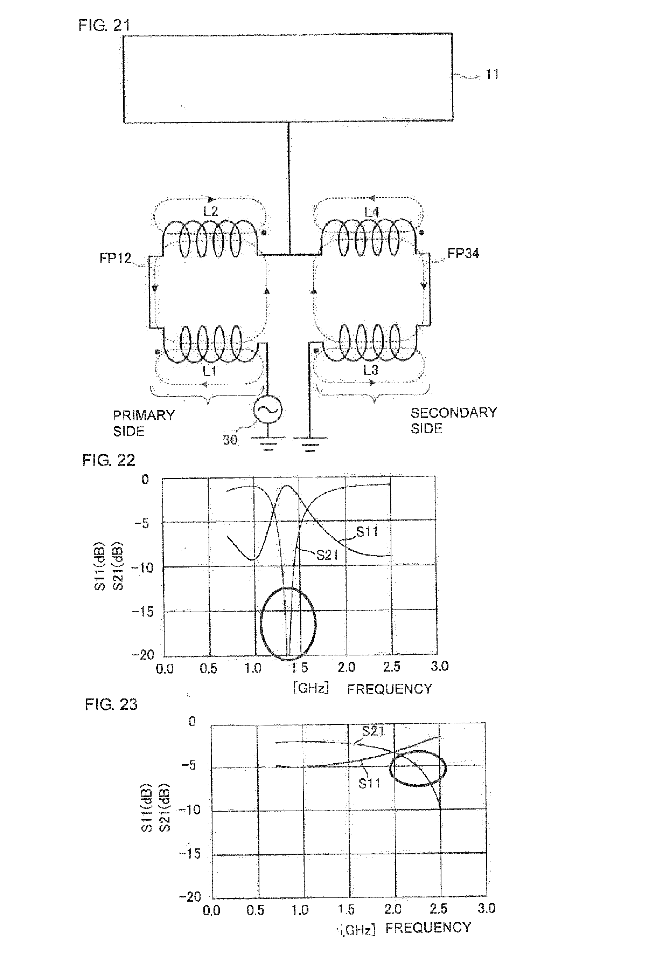

Fig. 21 is a diagram illustrating a relationship between magnetic connections of the four coiled conductors L1 to L4 in the frequency stabilization circuit according to the fourth embodiment. In this way, a first closed magnetic circuit (a loop indicated by a magnetic flux FP12) is configured on the basis of the first coiled conductor L1 and the second coiled conductor L2. In addition, a second closed magnetic circuit (a loop indicated by a magnetic flux FP34) is configured on the basis of the third coiled conductor L3 and the fourth coiled conductor L4. The direction of the magnetic flux FP12 passing through the first closed magnetic circuit and the direction of the magnetic flux FP34 passing through the second closed magnetic circuit are opposite to each other.

Here, when the first coiled conductor I1 and the second coiled conductor L2 are expressed as a "primary-side", and the third coiled conductor L3 and the fourth coiled conductor L4 are expressed as a "secondary-side", since, as illustrated in Fig. 20, the power feeding circuit is connected to a portion located near the secondary-side, from among the primary-side, it is possible to heighten the electrical potential of a portion located near the secondary-side, from among the primary-side, and an induced current also flows on the secondary-side owing to a current flowing from the power feeding circuit. Therefore, magnetic fluxes illustrated in Fig. 21 occur.

Also according to the configuration of the fourth embodiment, since an inductance value between the coiled conductors L1 and L2 and an inductance value between the coiled conductors L3 and L4 become small owing to the individual coupling therebetween, the frequency stabilization circuit illustrated in the fourth embodiment also obtains the same advantageous effect as the frequency stabilization circuit 25 in the first embodiment.

«Fifth Embodiment»

In a fifth embodiment, an example of a configuration will be illustrated that is used for further enhancing the frequency of the self-resonance point of the transformer unit, compared with the first to fourth embodiments. In the frequency stabilization circuit 35 illustrated in Fig. 2, self-resonance based on LC resonance occurs owing to an inductance based on the primary-side series circuit 36 and the secondary-side series circuit 37 and a capacitance occurring between the primary-side series circuit 36 and the secondary-side series circuit 37.

Fig. 22 is a diagram illustrating the frequency characteristic of the frequency stabilization circuit 35 as the comparative example illustrated in Fig. 2. In Fig. 22, a curved line S21 indicates a transmission characteristic from the power feeding port to the antenna port, and S11 indicates a reflection characteristic on a power feeding port side. A region surrounded by an ellipse indicates a frequency region through which no electric power passes owing to the self-resonance. In this example, since reflection is large in a frequency band from 1.3 to 1.5 GHz and a transmission loss is large, electric power is hardly able to pass through this frequency band.

Fig. 23 is a diagram illustrating the frequency characteristic of the frequency stabilization circuit 25A illustrated in the third embodiment. In this frequency stabilization circuit 25A, it is possible to reduce the inductance of the transformer unit, and hence it is possible to enhance the frequency of the self-resonance point. According to the characteristic in Fig. 23, it is possible to use the frequency stabilization circuit 25A in a frequency band less than or equal to 2.0 GHz. In Fig. 23, a region surrounded by an ellipse indicates a frequency region through which no electric power passes owing to the self-resonance. The frequency of the self-resonance point is outside the scope of this drawing. In this example, since reflection is large in a frequency band greater than or equal to 2.3 GHz and a transmission loss is large, electric power is hardly able to pass through this frequency band.

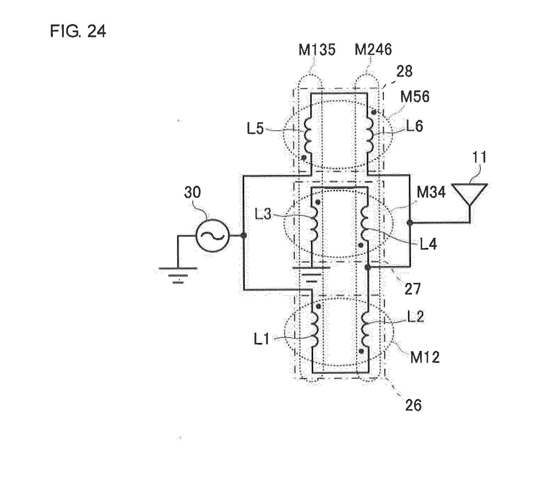

Fig. 24 is the circuit diagram of a frequency stabilization circuit according to the fifth embodiment. This frequency stabilization circuit includes the first series circuit 26 connected between the power feeding circuit 30 and the antenna 11, a third series circuit 28 connected between the power feeding circuit 30 and the antenna 11, and the second series circuit 27 connected between the antenna 11 and the ground.

The first series circuit 26 is a circuit in which the first coiled conductor L1 and the second coiled conductor L2 are connected in series to each other. The second series circuit 27 is a circuit in which the third coiled conductor L3 and the fourth coiled conductor L4 are connected in series to each other. The third series circuit 28 is a circuit in which a fifth coiled conductor L5 and a sixth coiled conductor L6 are connected in series to each other.

In Fig. 24, an enclosure M12 indicates coupling between the coiled conductors L1 and L2, an enclosure M34 indicates coupling between the coiled conductors L3 and L4, and an enclosure M56 indicates coupling between the coiled conductors L5 and L6. In addition, an enclosure M135 indicates coupling between the coiled conductors L1, L3, and L5. In the same way, an enclosure M246 indicates coupling between the coiled conductors L2, L4, and L6.

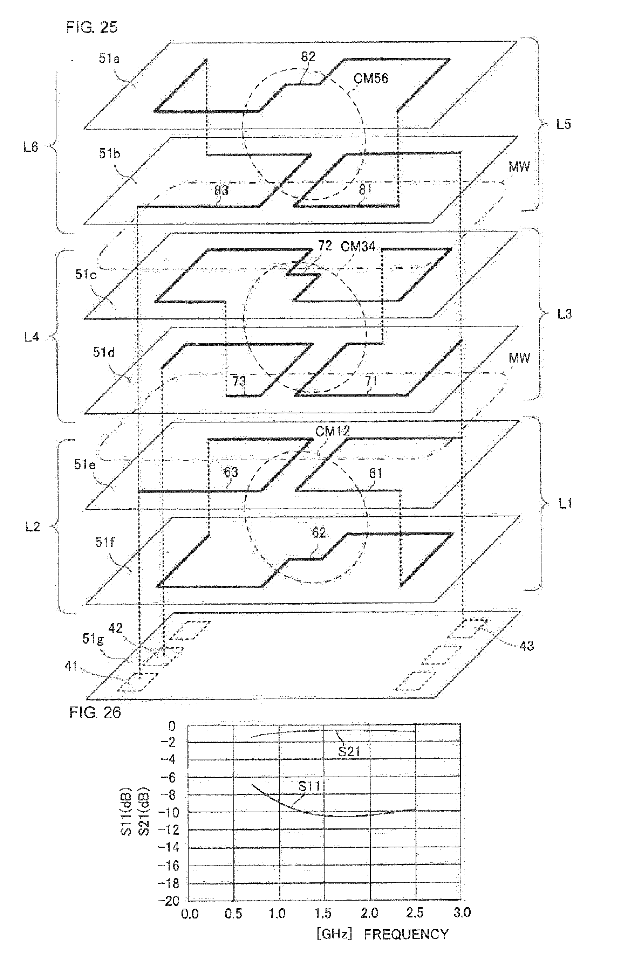

Fig. 25 is a diagram illustrating an example of the conductor pattern of each layer when the frequency stabilization circuit according to the fifth embodiment is configured in a multilayer substrate. While each layer includes a magnetic sheet and the conductor pattern of each layer is formed on the back surface of the magnetic sheet in a direction illustrated in Fig. 25, each conductor pattern is indicated by a solid line. In addition, while a linear conductor pattern has a predetermined line width, the linear conductor pattern is indicated by a simple solid line, here.

In a range illustrated in Fig. 25, a conductor pattern 82 is formed on the back surface of a first layer 51a, conductor patterns 81 and 83 are formed on the back surface of a second layer. 51b, and a conductor pattern 72 is formed on the back surface of a third layer 51c. Conductor patterns 71 and 73 are formed on the back surface of a fourth layer 51d, conductor patterns 61 and 63 are formed on the back surface of a fifth layer 51e, and a conductor pattern 62 is formed on the back surface of a sixth layer 51f. A power feeding terminal 41, a ground terminal 42, and an antenna terminal 43 are individually formed on the back surface of a seventh layer 51g. Dashed lines extending in a longitudinal direction in Fig. 25 are via electrodes, and connect conductor patterns to one another through interlayers. While actually these via electrodes are pillar-shaped electrodes having a predetermined diameter dimension, these via electrodes are indicated by simple dashed lines, here.

In Fig. 25, the first coiled conductor L1 is configured using the right half of the conductor pattern 62 and the conductor pattern. 61. In addition, the second coiled conductor L2 is configured using the left half of the conductor pattern 62 and the conductor pattern 63. In addition, the third coiled conductor L3 is configured using the conductor pattern 71 and the right half of the conductor pattern 72. In addition, the fourth coiled conductor L4 is configured using the left half of the conductor pattern 72 and the conductor pattern 73. In addition, the coiled conductor L5 is configured using the conductor pattern 81 and the right half of the conductor pattern 82. In addition, the sixth coiled conductor L6 is configured using the left half of the conductor pattern 82 and the conductor pattern 83.

In Fig. 25, the shape of an ellipse of a dashed line indicates a closed magnetic circuit. A closed magnetic circuit CM12 is interlinked with the coiled conductors L1 and L2. In addition, a closed magnetic circuit CM34 is interlinked with the coiled conductors L3 and L4. Furthermore, a closed magnetic circuit CM56 is interlinked with the coiled conductors L5 and L6. In this way, the first closed magnetic circuit CM12 is configured on the basis of the first coiled conductor L1 and the second coiled conductor L2, the second closed magnetic circuit CM34 is configured on the basis of the third coiled conductor L3 and the fourth coiled conductor L4, and the third closed magnetic circuit CM56 is configured on the basis of the fifth coiled conductor L5 and the sixth coiled conductor L6. In Fig. 25, the plain surfaces of two-dot chain lines are two magnetic barriers MW equivalently occurring between the above-mentioned three closed magnetic circuits owing to the fact that, in each of pairs of the coiled conductors L1 and L3, L3 and L5, L2 and L4, and L4 and L6, one coiled conductor and the other coiled conductor are coupled to each other so that magnetic fluxes occur in directions opposite to each other. In other words, the two magnetic barriers MW individually confide the magnetic flux of the closed magnetic circuit based on the coiled conductors L1 and L2, the magnetic flux of the closed magnetic circuit based on the coiled conductors L3 and L4, and the magnetic flux of the closed magnetic circuit based on the coiled conductors L5 and L6.

In this way, a structure is adopted in which the second closed magnetic circuit CM34 is sandwiched between the first closed magnetic circuit CM12 and the third closed magnetic circuit CM56 in a layer direction. According to this structure, the second closed magnetic circuit CM34 is sandwiched between two magnetic barriers and fully confined (a confining effect is enhanced). Namely, it is possible to be caused to function as a transformer whose coupling coefficient is very large.

Therefore, it is possible to widen, to some extent, a space between the closed magnetic circuits CM12 and CM34 and a space between the closed magnetic circuits CM34 and CM56. Here, when a circuit in which the series circuit based on the coiled conductors L1 and L2 and the series circuit based on the coiled conductors L5 and L6 are connected in parallel to each other is referred to as a primary-side circuit, and the series circuit based on the coiled conductors L3 and L4 is referred to as a secondary-side circuit, it is possible to reduce capacitances individually occurring between the first series circuit 26 and the second series circuit 27 and between the second series circuit 27 and the third series circuit 28, by widening a space between the closed magnetic circuits CM12 and CM34 and a space between the closed magnetic circuits CM34 and CM56. Namely, the capacitance component of an LC resonant circuit determining the frequency of the self-resonance point becomes small.

In addition, according to the fifth embodiment, since a structure is adopted in which the first series circuit 26 based on the coiled conductors L1 and L2 and the third series circuit 28 based on the coiled conductors L5 and L6 are connected in parallel to each other, the inductance component of the LC resonant circuit determining the frequency of the self-resonance point becomes small.

In this way, both the capacitance component and the inductance component of the LC resonant circuit determining the frequency of the self-resonance point become small, and hence it is possible to set the frequency of the self-resonance point to a high frequency fully distant from a usable frequency band.

Fig. 26 is a diagram illustrating the frequency characteristic of the frequency stabilization circuit illustrated in the fifth embodiment. Since, in the frequency stabilization circuit, the frequency of the self-resonance point is a high frequency outside the scope of this drawing, it is possible to use the frequency stabilization circuit in a wide frequency band from 0.7 to 2.5 GHz, for example.

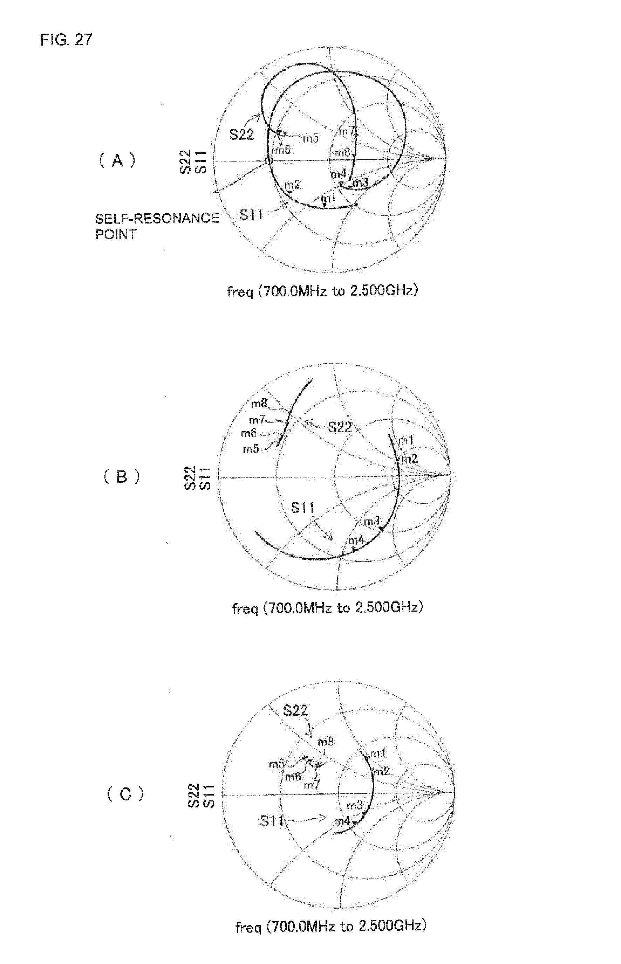

Fig. 27(A) is a diagram illustrating the reflection characteristic of the frequency stabilization circuit 35 as the comparative example illustrated in Fig. 2. Fig. 27 (B) is a diagram illustrating the reflection characteristic of the frequency stabilization circuit 25A illustrated in the third embodiment. Fig. 27(C) is a diagram illustrating the reflection characteristic of the frequency stabilization circuit according to the fifth embodiment. Here, a locus when a frequency is swept from 700 MHz to 2.50 GHz is indicated on a Smith chart. A reflection characteristic S11 is the locus of the reflection characteristic from the power feeding port, and a reflection characteristic S22 is the locus of the reflection characteristic from the antenna port.

Here, a correspondence relationship between each marker and a frequency is as follows.

(m1, m5): 824.0 MHz
(m2, m6): 960.0 MHz
(m3, m7): 1.710 GHz
(m4, m8): 1.960 GHz

As expressed in Fig. 27(A), since, in the frequency stabilization circuit 35 as the comparative example illustrated in Fig. 2, both an L property and a C property are strong, a locus is very large and has a self-resonance point. In Fig. 27(A), a circle-marked position is the self-resonance point.

As expressed in Fig. 27(B), in the frequency stabilization circuit 25A illustrated in the third embodiment, it is understood that the self-resonance point (a point intersecting with jx = 0 on a short side) disappears, by reducing the L property.

As expressed in Fig. 27(C), in the frequency stabilization circuit illustrated in the fifth embodiment, it is understood that a locus becomes even smaller and recedes from a short position, by reducing the C property.

«Sixth Embodiment»

In a sixth embodiment, an example of a configuration will be illustrated that is different from the configuration of the fifth embodiment and used for further enhancing the frequency of the self-resonance point of the transformer unit, compared with the first to fourth embodiments.

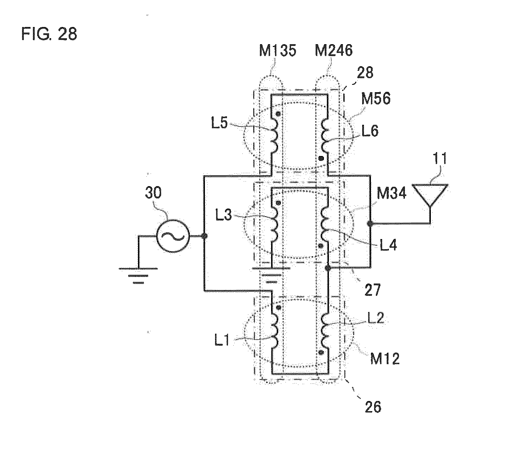

Fig. 28 is the circuit diagram of a frequency stabilization circuit according to a sixth embodiment. This frequency stabilization circuit includes the first series circuit 26 connected between the power feeding circuit 30 and the antenna 11, the third series circuit 28 connected between the power feeding circuit 30 and the antenna 11, and the second series circuit 27 connected between the antenna 11 and the ground.

The first series circuit 26 is a circuit in which the first coiled conductor L1 and the second coiled conductor L2 are connected in series to each other. The second series circuit 27 is a circuit in which the third coiled conductor L3 and the fourth coiled conductor L4 are connected in series to each other. The third series circuit 28 is a circuit in which the fifth coiled conductor L5 and the sixth coiled conductor L6 are connected in series to each other.

In Fig. 28, an enclosure M12 indicates coupling between the coiled conductors L1 and L2, an enclosure M34 indicates coupling between the coiled conductors L3 and L4, and an enclosure M56 indicates coupling between the coiled conductors L5 and L6. In addition, an enclosure M135 indicates coupling between the coiled conductors L1, L3, and L5. In the same way, an enclosure M246 indicates coupling between the coiled conductors L2, L4, and L6.

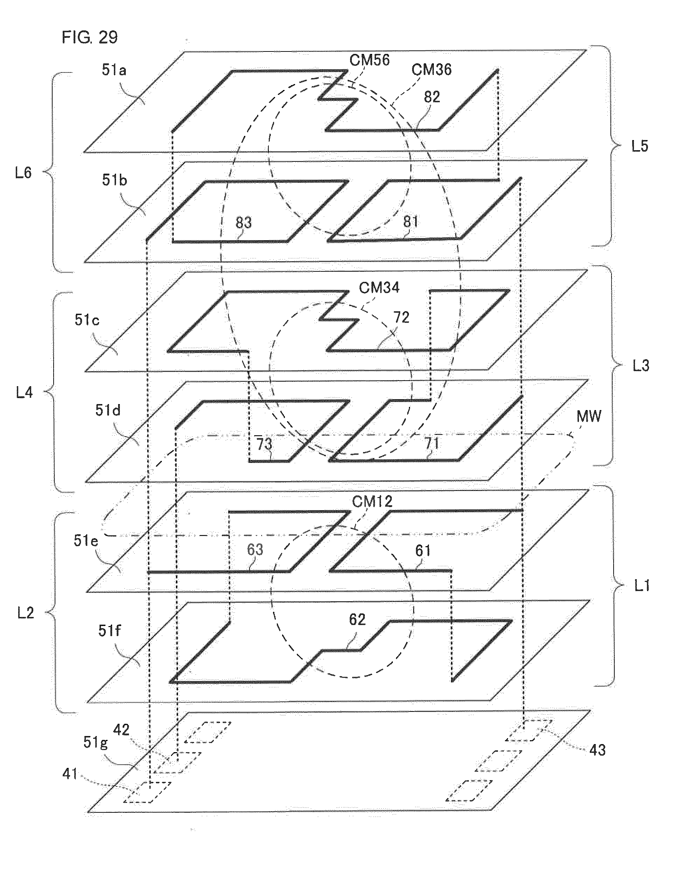

Fig. 29 is a diagram illustrating an example of the conductor pattern of each layer when the frequency stabilization circuit according to the sixth embodiment is configured in a multilayer substrate. While each layer includes a magnetic sheet and the conductor pattern of each layer is formed on the back surface of the magnetic sheet in a direction illustrated in Fig. 29, each conductor pattern is indicated by a solid line. In addition, while a linear conductor pattern has a predetermined line width, the linear conductor pattern is indicated by a simple solid line, here.

The polarities of the coiled conductors L5 and L6 based on the conductor patterns 81, 82, and 83 differ from the frequency stabilization circuit illustrated in Fig. 25. In the example of Fig. 29, a closed magnetic circuit CM36 is interlinked with the coiled conductors L3, L5, L6, and L4. Accordingly, no equivalent magnetic barrier occurs between the coiled conductors L3 and L4 and the coiled conductors L5 and L6. The other configuration is the same as illustrated in the fifth embodiment.

According to the sixth embodiment, the closed magnetic circuits CM12, CM34, and CM56 occur and the closed magnetic circuit CM36 occurs, and hence a magnetic flux based on the coiled conductors L3 and L4 is absorbed by a magnetic flux based on the coiled conductors L5 and L6. Therefore, also in the structure of the sixth embodiment, it is hard for a magnetic flux to leak, and as a result, it is possible to be caused to function as a transformer whose coupling coefficient is very large.

Also in the sixth embodiment, both the capacitance component and the inductance component of the LC resonant circuit determining the frequency of the self-resonance point become small, and hence it is possible to set the frequency of the self-resonance point to a high frequency fully distant from a usable frequency band.

«Seventh Embodiment»

In a seventh embodiment, an example of another configuration will be illustrated that is different from the configurations of the fifth embodiment and the sixth embodiment and used for further enhancing the frequency of the self-resonance point of the transformer unit, compared with the first to fourth embodiments.

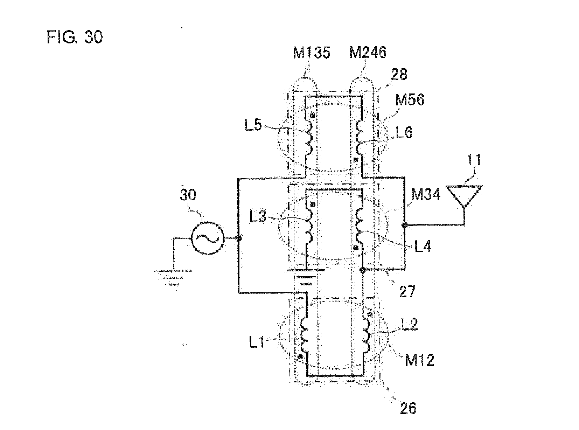

Fig. 30 is the circuit diagram of a frequency stabilization circuit according to a seventh embodiment. This frequency stabilization circuit includes the first series circuit 26 connected between the power feeding circuit 30 and the antenna 11, the third series circuit 28 connected between the power feeding circuit 30 and the antenna 11, and the second series circuit 27 connected between the antenna 11 and the ground.

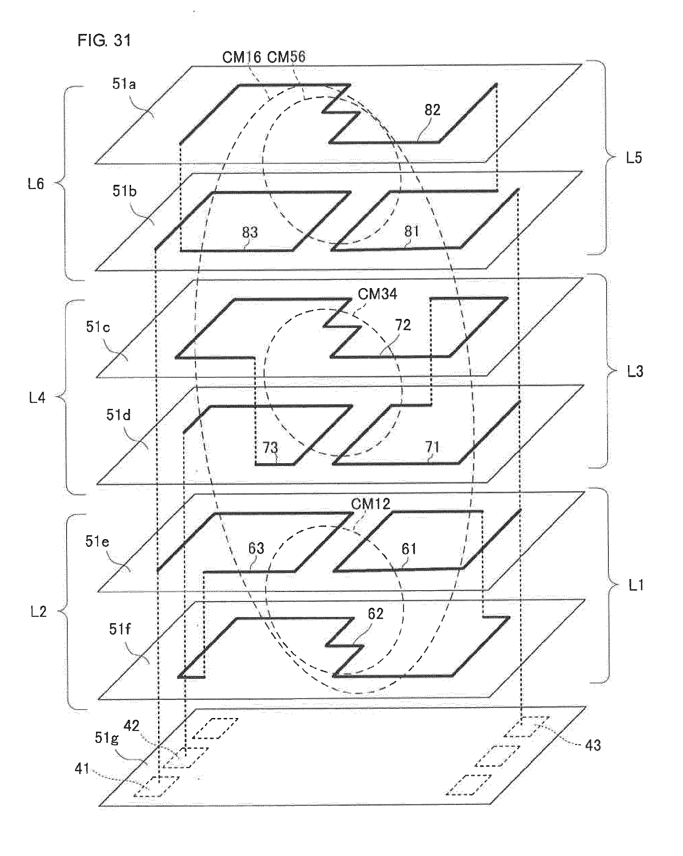

Fig. 31 is a diagram illustrating an example of the conductor pattern of each layer when the frequency stabilization circuit according to the seventh embodiment is configured in a multilayer substrate. While each layer includes a magnetic sheet and the conductor pattern of each layer is formed on the back surface of the magnetic sheet in a direction illustrated in Fig. 31, each conductor pattern is indicated by a solid line. In addition, while a linear conductor pattern has a predetermined line width, the linear conductor pattern is indicated by a simple solid line, here.

The polarities of the coiled conductors L1 and L2 based on the conductor patterns 61, 62, and 63 and the polarities of the coiled conductors L5 and L6 based on the conductor patterns 81, 82, and 83 differ from the frequency stabilization circuit illustrated in Fig. 25. In the example of Fig. 31, a closed magnetic circuit CM16 is interlinked with all the coiled conductors L1 to L6. Accordingly, no equivalent magnetic barrier occurs in this case. The other configuration is as illustrated in the fifth embodiment and the sixth embodiment.

According to the seventh embodiment, the closed magnetic circuits CM12, CM34, and CM56 illustrated in Fig. 31 occur and the closed magnetic circuit CM16 occurs, and hence it is hard for magnetic fluxes based on the coiled conductors L1 to L6 to leak, and as a result, it is possible to be caused to function as a transformer whose coupling coefficient is large.

Also in the seventh embodiment, both the capacitance component and the inductance component of the LC resonant circuit determining the frequency of the self-resonance point become small, and hence it is possible to set the frequency of the self-resonance point to a high frequency fully distant from a usable frequency band.

«Eighth Embodiment»

A communication terminal device of the present invention includes the frequency stabilization circuit illustrated in one of the first to seventh embodiments, a radiator, and a power feeding circuit connected to the power feeding port of the frequency stabilization circuit. The power feeding circuit includes an antenna switch and a high-frequency circuit including a transmitting circuit and a receiving circuit. In addition to this, the communication terminal device includes a modulation/demodulation circuit and a baseband circuit.

Reference Signs List

Ca capacitor
CM12, CM34, CM56 closed magnetic circuit
CM36, CM16 closed magnetic circuit
FP12, FP13, FP24, FP34 magnetic flux
L1 first coiled conductor
L2 second coiled conductor
L3 third coiled conductor
L4 fourth coiled conductor
L5 fifth coiled conductor
L6 sixth coiled conductor
11 radiator
11D radiator
25 frequency stabilization circuit
26 first series circuit
27 second series circuit
28 third series circuit
30 power feeding circuit
41 power feeding terminal
42 ground terminal
43 antenna terminal
51a to 51h layer
61 to 65 conductor pattern
66 conductor pattern
71 to 75 conductor pattern
81 to 83 conductor pattern

**Claims**

1. A frequency stabilization circuit comprising:

   at least a first coiled conductor, a second coiled conductor, a third coiled conductor, and a fourth coiled conductor, wherein
   the first coiled conductor and the second coiled conductor are connected in series to each other, thereby configuring a first series circuit,
   the third coiled conductor and the fourth coiled conductor are connected in series to each other, thereby configuring a second series circuit,
   the first coiled conductor and the second coiled conductor are wound so that a first closed magnetic circuit is configured on the basis of the first coiled conductor and the second coiled conductor, and
   the third coiled conductor and the fourth coiled conductor are wound so that a second closed magnetic circuit is configured on the basis of the third coiled conductor and the fourth coiled conductor.

2. The frequency stabilization circuit according to Claim 1, wherein
   the first coiled conductor, the second coiled conductor, the third coiled conductor, and the fourth coiled conductor are wound so that the direction of a magnetic flux passing through the first closed magnetic circuit and the direction of a magnetic flux passing through the second closed magnetic circuit are opposite to each other.

3. The frequency stabilization circuit according to Claim 1, wherein
   the first coiled conductor and the third coiled conductor are magnetically coupled to each other, and
   the second coiled conductor and the fourth coiled conductor are magnetically coupled to each other.

4. The frequency stabilization circuit according to any one of Claims 1 to 3, wherein
   a capacitor is connected between an antenna port connected to an antenna and ground.

5. The frequency stabilization circuit according to any one of Claims 1 to 4, wherein
   the first coiled conductor, the second coiled conductor, the third coiled conductor, and the fourth coiled conductor are configured by a conductor pattern within a common multilayer substrate.

6. The frequency stabilization circuit according to Claim 5, wherein
   a winding axis of each of the first coiled conductor, the second coiled conductor, the third coiled conductor, and the fourth coiled conductor is oriented in a lamination direction of the multilayer substrate,
   the individual winding axes of the first coiled conductor and the second coiled conductor are placed side by side in a different relationship,
   the individual winding axes of the third coiled conductor and the fourth coiled conductor are placed side by side in a different relationship, and
   a winding range of the first coiled conductor and a winding range of the third coiled conductor at least partly overlap with each other in planar view, and a winding range of the second coiled conductor and a winding range of the fourth coiled conductor at least partly overlap with each other in planar view.

7. A frequency stabilization circuit comprising:

   at least a first coiled conductor, a second coiled conductor, a third coiled conductor, a fourth coiled conductor, a fifth coiled conductor, and a sixth coiled conductor, wherein
   the first coiled conductor and the second coiled conductor are connected in series to each other, thereby configuring a first series circuit,
   the third coiled conductor and the fourth coiled conductor are connected in series to each other, thereby configuring a second series circuit,
   the fifth coiled conductor and the sixth coiled conductor are connected in series to each other, thereby configuring a third series circuit,
   the first coiled conductor and the second coiled conductor are wound so that a first closed magnetic circuit is configured on the basis of the first coiled conductor and the second coiled conductor,
   the third coiled conductor and the fourth coiled conductor are wound so that a second closed magnetic circuit is configured on the basis of the third coiled conductor and the fourth coiled conductor,
   the fifth coiled conductor and the sixth coiled conductor are wound so that a third closed magnetic circuit is configured on the basis of the fifth coiled conductor and the sixth coiled conductor, and

the second closed magnetic circuit is sandwiched between the first closed magnetic circuit and the third closed magnetic circuit in a layer direction.

8. The frequency stabilization circuit according to claim 7, wherein
the first coiled conductor, the second coiled conductor, the third coiled conductor, and the fourth coiled conductor are wound so that the direction of a magnetic flux passing through the first closed magnetic circuit and the direction of a magnetic flux passing through the second closed magnetic circuit are opposite to each other, and
the third coiled conductor, the fourth coiled conductor, the fifth coiled conductor, and the sixth coiled conductor are wound so that the direction of a magnetic flux passing through the second closed magnetic circuit and the direction of a magnetic flux passing through the third closed magnetic circuit are opposite to each other.

9. The frequency stabilization circuit according to claim 7, wherein
the first coiled conductor, the second coiled conductor, the third coiled conductor, and the fourth coiled conductor are wound so that the direction of a magnetic flux passing through the first closed magnetic circuit and the direction of a magnetic flux passing through the second closed magnetic circuit are opposite to each other, and
the third coiled conductor, the fourth coiled conductor, the fifth coiled conductor, and the sixth coiled conductor are wound so that the direction of a magnetic flux passing through the second closed magnetic circuit and the direction of a magnetic flux passing through the third closed magnetic circuit are equal to each other.

10. An antenna device comprising:

a frequency stabilization circuit including a power feeding port connected to a power feeding circuit and an antenna port connected to an antenna and an antenna connected to the antenna port, wherein
the frequency stabilization circuit includes
at least a first coiled conductor, a second coiled conductor, a third coiled conductor, and a fourth coiled conductor, wherein
the first coiled conductor and the second coiled conductor are connected in series to each other, thereby configuring a first series circuit,
the third coiled conductor and the fourth coiled conductor are connected in series to each other, thereby configuring a second series circuit,
the first series circuit is connected between the antenna port and the power feeding port,
the second series circuit is connected between the antenna port and ground,
the first coiled conductor and the second coiled conductor are wound so that a first closed magnetic circuit is configured on the basis of the first coiled conductor and the second coiled conductor, and
the third coiled conductor and the fourth coiled conductor are wound so that a second closed magnetic circuit is configured on the basis of the third coiled conductor and the fourth coiled conductor.

11. An antenna device comprising:

a frequency stabilization circuit including a power feeding port connected to a power feeding circuit and an antenna port connected to an antenna and an antenna connected to the antenna port, wherein
the frequency stabilization circuit includes
at least a first coiled conductor, a second coiled conductor, a third coiled conductor, a fourth coiled conductor, a fifth coiled conductor, and a sixth coiled conductor, wherein
the first coiled conductor and the second coiled conductor are connected in series to each other, thereby configuring a first series circuit,
the third coiled conductor and the fourth coiled conductor are connected in series to each other, thereby configuring a second series circuit,
the fifth coiled conductor and the sixth coiled conductor are connected in series to each other, thereby configuring a third series circuit,
the first series circuit and the third series circuit are connected in parallel to each other between the antenna port and the power feeding port,
the second series circuit is connected between the antenna port and ground,
the first coiled conductor and the second coiled conductor are wound so that a first closed magnetic circuit is configured on the basis of the first coiled conductor and the second coiled conductor,
the third coiled conductor and the fourth coiled conductor are wound so that a second closed magnetic circuit is configured on the basis of the third coiled conductor and the fourth coiled conductor,
the fifth coiled conductor and the sixth coiled conductor are wound so that a third closed magnetic circuit is configured on the basis of the fifth coiled conductor and the sixth coiled conductor, and
the second closed magnetic circuit is sandwiched between the first closed magnetic circuit and the third closed magnetic circuit in a layer direction.

12. A communication terminal device comprising:

a frequency stabilization circuit including a power feeding port connected to a power feeding circuit and an antenna port connected to an antenna, an antenna connected to the antenna port, and a power feeding circuit connected to the power feeding port, wherein
the frequency stabilization circuit includes
at least a first coiled conductor, a second coiled conductor, a third coiled conductor, and a fourth coiled conductor, wherein
the first coiled conductor and the second coiled conductor are connected in series to each other, thereby configuring a first series circuit,
the third coiled conductor and the fourth coiled conductor are connected in series to each other, thereby configuring a second series circuit,
the first series circuit is connected between the antenna port and the power feeding port,
the second series circuit is connected between the antenna port and ground,
the first coiled conductor and the second coiled conductor are wound so that a first closed magnetic circuit is configured on the basis of the first coiled conductor and the second coiled conductor, and
the third coiled conductor and the fourth coiled conductor are wound so that a second closed magnetic circuit is configured on the basis of the third coiled conductor and the fourth coiled conductor.

13. A communication terminal device comprising:

a frequency stabilization circuit including a power feeding port connected to a power feeding circuit and an antenna port connected to an antenna, an antenna connected to the antenna port, and a power feeding circuit connected to the power feeding port, wherein
the frequency stabilization circuit includes
at least a first coiled conductor, a second coiled conductor, a third coiled conductor, a fourth coiled conductor, a fifth coiled conductor, and a sixth coiled conductor, wherein
the first coiled conductor and the second coiled conductor are connected in series to each other, thereby configuring a first series circuit,
the third coiled conductor and the fourth coiled conductor are connected in series to each other, thereby configuring a second series circuit,
the fifth coiled conductor and the sixth coiled conductor are connected in series to each other, thereby configuring a third series circuit,
the first series circuit and the third series circuit are connected in parallel to each other between the antenna port and the power feeding port,
the second series circuit is connected between the antenna port and ground,
the first coiled conductor and the second coiled conductor are wound so that a first closed magnetic circuit is configured on the basis of the first coiled conductor and the second coiled conductor,
the third coiled conductor and the fourth coiled conductor are wound so that a second closed magnetic circuit is configured on the basis of the third coiled conductor and the fourth coiled conductor,
the fifth coiled conductor and the sixth coiled conductor are wound so that a third closed magnetic circuit is configured on the basis of the fifth coiled conductor and the sixth coiled conductor, and
the second closed magnetic circuit is sandwiched between the first closed magnetic circuit and the third closed magnetic circuit in a layer direction.

FIG. 1

（A）

11

25

30

（B）

11D

30

FIG. 2

35

37

L4      L3

11

36

L2      L1

30

FIG. 3

（A）

（B）

FIG. 4

FIG. 5

（A）

（B）

FIG. 6

(A)

(B)

FIG. 7

FIG. 8

FIG. 9

FP34

73
74
75

73
74
75

73
72
71

73
72
71

63
64
65

63
64
65

63
62
61

63
62
61

FP12

FIG. 10

11

L2

L4

FP12

FP34

25

L1

L3

30

FIG. 11

S11

freq (700.0MHz to 2.300GHz)

FIG. 12

FIG. 13

FIG. 14

FIG. 15

FIG. 16

FIG. 17

(A)

freq (700.0MHz to 2.300GHz)

(B)

freq (700.0MHz to 2.300GHz)

FIG. 18

(A)

freq (700.0MHz to 2.300GHz)

(B)

freq (700.0MHz to 2.300GHz)

FIG. 19

(A)

S11

freq (700.0MHz to 2.300GHz)

(B)

[GHz]
FREQUENCY

FIG. 20

EP 2 453 581 A1

FIG. 21

FP12    L2        L4    FP34

L1        L3

PRIMARY          SECONDARY
SIDE             SIDE
30

FIG. 22

S11
S21

S11(dB)
S21(dB)

0.0  0.5  1.0  1.5  2.0  2.5  3.0
[GHz]   FREQUENCY

FIG. 23

S21
S11

S11(dB)
S21(dB)

0.0  0.5  1.0  1.5  2.0  2.5  3.0
[GHz]  FREQUENCY

33

FIG. 24

FIG. 25

FIG. 26

FIG. 27

(A)

freq (700.0MHz to 2.500GHz)

(B)

freq (700.0MHz to 2.500GHz)

(C)

freq (700.0MHz to 2.500GHz)

FIG. 28

FIG. 29

FIG. 30

EP 2 453 581 A1

FIG. 31

40

<div align="center">

**INTERNATIONAL SEARCH REPORT**

</div>

| | International application No. |
|---|---|
| | PCT/JP2011/050883 |

**A. CLASSIFICATION OF SUBJECT MATTER**
*H04B1/40*(2006.01)i, *H01P5/08*(2006.01)i, *H01Q1/24*(2006.01)i

According to International Patent Classification (IPC) or to both national classification and IPC

**B. FIELDS SEARCHED**

Minimum documentation searched (classification system followed by classification symbols)
H04B1/40, H01P5/08, H01Q1/24

Documentation searched other than minimum documentation to the extent that such documents are included in the fields searched
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 2000-244273 A (Toko, Inc.),<br>08 September 2000 (08.09.2000),<br>paragraphs [0008], [0016], [0017]; fig. 1, 5, 6<br>(Family: none) | 1-3,5-13<br>4 |
| Y<br>A | JP 2004-304615 A (TDK Corp.),<br>28 October 2004 (28.10.2004),<br>paragraphs [0025], [0029], [0030]; fig. 3<br>(Family: none) | 1-3,5-13<br>4 |
| A | JP 2009-246624 A (Hitachi Metals, Ltd.),<br>22 October 2009 (22.10.2009),<br>entire text; all drawings<br>(Family: none) | 1-13 |

☒ Further documents are listed in the continuation of Box C. ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 19 April, 2011 (19.04.11) | 26 April, 2011 (26.04.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
|---|
| PCT/JP2011/050883 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2005-323132 A  (Kyocera Corp.), 17 November 2005 (17.11.2005), entire text; all drawings & JP 4295660 B2 | 1-13 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004172919 A
- JP 2005006096 A
- JP 2008118359 A